(19) Europäisches Patentamt / European Patent Office / Office européen des brevets

(11) **EP 4 178 905 B1**

(12) **EUROPÄISCHE PATENTSCHRIFT**

(45) Veröffentlichungstag und Bekanntmachung des Hinweises auf die Patenterteilung:
**28.08.2024 Patentblatt 2024/35**

(21) Anmeldenummer: **21739328.9**

(22) Anmeldetag: **01.07.2021**

(51) Internationale Patentklassifikation (IPC):
**B81C 1/00** *(2006.01)* **B81B 7/00** *(2006.01)*

(52) Gemeinsame Patentklassifikation (CPC):
**B81C 1/00309; B81B 7/0061;** B81B 2201/0214;
B81B 2201/0257; B81B 2201/0271;
B81B 2207/012; B81C 2201/018; B81C 2201/0181;
B81C 2201/0188; B81C 2203/0136

(86) Internationale Anmeldenummer:
**PCT/EP2021/068165**

(87) Internationale Veröffentlichungsnummer:
**WO 2022/008338 (13.01.2022 Gazette 2022/02)**

(54) **KOMPAKTES UND EINFACH HERZUSTELLENDES MEMS-PACKAGE MIT VERBESSERTEN SCHUTZEIGENSCHAFTEN**

COMPACT MEMS PACKAGE WHICH IS EASY TO MANUFACTURE HAVING IMPROVED PROTECTION PROPERTIES

BOÎTIER DE SYSTÈME MICROÉLECTROMÉCANIQUE COMPACT ET FACILE À FABRIQUER AYANT DES PROPRIÉTÉS DE PROTECTION AMÉLIORÉES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.07.2020 EP 20184559**
**19.10.2020 EP 20202552**

(43) Veröffentlichungstag der Anmeldung:
**17.05.2023 Patentblatt 2023/20**

(73) Patentinhaber: **Hahn-Schickard-Gesellschaft für angewandte Forschung e. V.**
**70569 Stuttgart (DE)**

(72) Erfinder:
• **BITTNER, Achim**
**74080 Heilbronn (DE)**
• **DEHÉ, Alfons**
**72770 Reutlingen (DE)**

(74) Vertreter: **Hertin und Partner Rechts- und Patentanwälte PartG mbB**
**Kurfürstendamm 54/55**
**10707 Berlin (DE)**

(56) Entgegenhaltungen:
**US-A1- 2009 026 560     US-A1- 2019 148 566**
**US-A1- 2019 311 961     US-B1- 6 956 283**

• **FEIERTAG G ET AL: "Flip chip MEMS microphone package with large acoustic reference volume", PROCEDIA ENGINEERING, ELSEVIER BV, NL, vol. 5, 1 January 2010 (2010-01-01), pages 355 - 358, XP027483677, ISSN: 1877-7058, [retrieved on 20101025], DOI: 10.1016/J.PROENG.2010.09.121**

**Beschreibung**

Die Erfindung betrifft bevorzugt ein MEMS-Package mit mindestens einer Schicht zum Schutz eines MEMS-Elements, wobei das MEMS-Element mindestens einen MEMS-Interaktionsbereich auf einem Substrat aufweist und eine oberflächenkonforme Beschichtung vom MEMS-Element mit einer dielektrischen Schicht erfolgt. Besonders bevorzugt betrifft die Erfindung ein MEMS-Transducer Package, bei dem ein MEMS-Element, beispielsweise mit einer MEMS-Membran und einem Prozessor, vorzugsweise einer integrierten Schaltung, auf einem Substrat angeordnet vorliegen. Zum Schutz erfolgt bevorzugt zunächst eine oberflächenkonforme Beschichtung eines Dielektrikums auf das MEMS-Element beispielsweise durch Sprühbeschichtung, Nebelbeschichtung und/oder Dampfbeschichtung. Anschließend wird bevorzugt eine elektrisch leitende Schicht aufgebracht. Je nach Konfiguration können die Schichten in Bereichen oberhalb eines MEMS-Interaktionsbereich des MEMS-Elementes entfernt werden, beispielsweise für eine Schallöffnung einer MEMS-Membran.

Hintergrund und Stand der Technik

Für die Herstellung kompakter, mechanisch-elektronischer Vorrichtungen wird heute auf vielen Anwendungsgebieten auf die Mikrosystemtechnik zurückgegriffen. Die so herstellbaren Mikrosysteme (engl. *microelectromechanical system,* kurz MEMS) sind sehr kompakt (Mikrometerbereich) bei gleichzeitig hervorragender Funktionalität und immer geringeren Herstellungskosten.

Anwendungsgebiete der MEMS-Technologie umfassen beispielsweise MEMS-basierte optischen Emittern oder Empfängern, Filter, elektrochemische Sensoren, Gas-Sensoren oder auch akustische MEMS-Tranducer.

MEMS-Tranducer sind vorzugsweise MEMS-Schallwandler und können beispielsweise als MEMS-Mikrofone oder als MEMS-Lautsprecher ausgestaltet sein. Es können auch beide Funktionalitäten von einem MEMS-Transducer erfüllt werden. Derartige MEMS-Transducer kommen beispielsweise bei modernen Smartphones zum Einsatz.

MEMS-Transducer umfassen bevorzugt einen MEMS-Baustein (z. B. MEMS-Chip) mit einer schwingfähigen Membran, dessen Schwingungen beispielsweise durch piezoelektrische oder piezoresistive Komponenten auf bzw. an der Membran erzeugt und/oder ausgelesen werden. Ebenso sind kapazitive Methoden zur Erzeugung und/oder Messung von Schwingungen der Membran bekannt.

Die MEMS-Transducer werden oftmals auf einem Substrat gemeinsam mit einer integrierten Schaltung (IC) zur Steuerung und/oder Auswertung der Schwingungen angeordnet und stehen mit diesen über elektrische Verbindungen, welche beispielsweise durch Drahtbonds erfolgen und/oder im Substrat, z. B. durch Leiterbahnen angelegt sind, in Kontakt. Das Substrat fungiert insbesondere als Träger und kann z. B. als Printed Circuit Board (PCB) oder als Keramik ausgestaltet sein. Neben der Trägerfunktion kann es vorzugsweise auch elektrische Funktionen realisieren, z. B. elektrische Verbindungen für die einzelnen Komponenten bereitstellen.

Bei einem IC handelt es sich bevorzugt um ein Elektronikbauteil, durch den eine Steuerungseinheit oder eine Regelungseinheit realisiert wird. Insbesondere handelt es sich um einen Elektronikchip. Dieser kann bspw. eine anwendungsspezifische integrierte Schaltung (ASIC) aufweisen, welche insbesondere für die Massenproduktion geeignet ist. Es kann sich jedoch auch um eine programmierbare logische Schaltung (PLD) handeln, z. B. ein Field Programmable Gate Array (FPGA), insbesondere für individuelle Anwendungen.

MEMS-Elemente, wie beispielsweise ein MEMS-Transducer, sind zumeist empfindlich gegenüber äußeren Einflüssen und werden daher durch ein sogenanntes Packaging geschützt.

In dieser Hinsicht erfüllt das Packaging von MEMS-Elementen mehrere Aufgaben. Dazu gehört der Schutz des Bauteils vor Staub, Feuchte und Flüssigkeiten, sowie vor ESD (elektrostatischen Entladungen). Gleichzeitig sollen jedoch die funktionellen Eigenschaften des MEMS-Elementes, beispielsweise die akustischen Eigenschaften eines akustischen MEMS-Transducers, erhalten bleiben.

Das Package erfüllt vorzugsweise eine Gehäusefunktion für das MEMS-Element. Auf einer Unterseite des MEMS-Elementes kann ein Substrat selbst diese Funktion erfüllen. Zusätzlich wird oberhalb des Substrats für die auf diesem angeordneten Komponenten Schutz benötigt.

Das MEMS-Bauelement bzw. der MEMS-Baustein kann konventionell oder in sogenannter Flip-Chip-Montage auf dem Substrat angeordnet vorliegen, wobei der Chip mit der aktiven Kontaktierungsseite nach unten zum Substrat hin montiert wird und ohne weitere Anschlussdrähte auskommt. Dafür weist das Substrat bevorzugt selbst Kontaktierungshügel (Bumps) auf. Dies führt vorteilhafterweise zu geringen Abmessungen des Gehäuses und kurzen Längen der elektrischen Leiter.

Der MEMS-Baustein bzw. das MEMS-Bauelement und/oder die MEMS-Membran kann bei einem akustischen MEMS-Transducer auf unterschiedliche Arten auf dem Substrat angeordnet vorliegen.

Dasjenige Volumen, indem von der MEMS-Membran aus gesehen Schallwellen gemessen und/oder erzeugt werden sollen, wird vorzugsweise als Frontvolumen bezeichnet. Die andere Seite wird vorzugsweise als Rückvolumen bezeichnet. Dieses ist vorzugsweise abgeschlossen und weist außer ggf. über eine Öffnung in der Membran keine direkte Verbindung zum Frontvolumen auf. Je nach Anordnung kann das Rückvolumen z. B. zwischen Membran und Substrat liegen.

Dann liegt das Frontvolumen oberhalb von MEMS-Baustein und Träger. Eine hier liegende Gehäusekomponente (z. B. eine Abdeckung), welche das Package nach oben abschließt, weist vorzugsweise in diesem Bereich eine Schallöffnung auf.

Das Rückvolumen kann jedoch auch zwischen Membran und der oberhalb von MEMS-Baustein und Substrat angeordneten Gehäusekomponente liegen. Diese ist dann vorzugsweise komplett geschlossen. Das Frontvolumen liegt dann bevorzugt zwischen Membran und einer Schallöffnung im Substrat. Abmessungen und Geometrie dieser Volumina sowie deren Größenverhältnis beeinflussen die akustischen Eigenschaften des MEMS-Transducers. Die MEMS-Membran kann vorzugsweise bei beiden beschriebenen Konstellationen innerhalb der Bauhöhe des MEMS-Bauelements entweder an einem oberen Ende angeordnet vorliegen oder an einem unteren Ende, zum Substrat hin.

Im Falle eines MEMS-Transducers liegen die elektrische Komponente des MEMS-Bausteins selbst, z. B. Elektroden eines kapazitiven MEMS-Transducers vorzugsweise im Rückvolumen oder zum Rückvolumen hin angeordnet vor (z. B. auf der zum Rückvolumen orientierten Seite der Membran), um beispielsweise die Vermessung einiger Flüssigkeiten durch die Membran ohne Kurzschluss oder Verunreinigungen dieser Komponenten zu ermöglichen. Hierdurch kann bevorzugt die Flüssigkeit direkt an der Membran anliegen. Auch ein genereller Schutz gegen Kurzschlüsse durch Feuchtigkeit wird so erreicht. Voraussetzung hierfür ist jedoch, dass das Package ein Eindringen von Feuchtigkeit/Flüssigkeit über die Schallöffnung in andere Bereiche des MEMS-Transducers verhindert. Eine Schallöffnung im Package sollte daher eine Öffnung nur zur Membran darstellen, nicht zu anderen Bereichen des MEMS-Transducers.

Im Stand der Technik bekannte Packages (s. bspw. Dehé et al. 2013) für MEMS-Transducer, weisen eine Metallabdeckung auf. Diese Abdeckungen schließen ein Volumen ein, welches deutlich größer ist als theoretisch für die darunter liegenden Komponenten des MEMS-Transducers benötigt. Der Hauptgrund hierfür ist, dass ein Abstand zwischen Abdeckung und den teils elektrisch leitenden Komponenten (z. B. Drahtbonds, Elektroden kapazitiver MEMS-Transducer etc.) eingehalten werden soll, um Kurzschlüsse zu vermeiden. Gleichzeitig ist Metall als Ausgangsmaterial für diese Abdeckungen erwünscht, da es mechanisch stabil und hermetisch dicht ist, insbesondere gegenüber Wasser und Luft. Hermetisch dicht bezeichnet insbesondere eine Dichtigkeit unter den üblichen Einsatzbedingungen des Transducers, also bevorzugt auch bei Drücken, welche erheblich über dem Atmosphärendruck liegen. Außerdem können empfindliche Komponenten elektromagnetisch abgeschirmt werden. So können negative Beeinflussungen und elektrostatische Entladungen (ESD) vermieden werden. Diese Abdeckungen konterkarieren jedoch die kompakte Bauweise moderner MEMS-Transducer.

Metallabdeckungen können mit einer Öffnung für den Schall versehen werden. Auch dann ist jedoch eine direkte Kontaktierung der MEMS-Membran mit einem zu vermessenden Material (Feststoff, Gas, Flüssigkeit) schwierig, weil die Öffnung mit einigem Abstand oberhalb der Membran angeordnet ist (s. o.) und dieser Abstand überwunden werden müsste. Außerdem kann dadurch, dass die Abdeckung samt Öffnung nicht mit den Komponenten des Transducers bündig abschließt, Flüssigkeit in den Zwischenraum zwischen Abdeckung und MEMS-Komponenten geraten, welcher Kurzschlüsse zwischen deren elektrisch leitenden Bereichen auslösen kann und das Eindringen von Schmutz und sonstigen schädlichen Substanzen fördert.

Eine Schallöffnung durch das Substrat (s. ebenfalls Dehé et al.) hat insbesondere den Nachteil, dass aufgrund der Abmessungen der Öffnung und der Länge der Öffnung, welche mindestens durch die Dicke des Substrats vorgegeben ist, ein Tiefpass für Schallfrequenzen entsteht, welcher insbesondere der Verwendbarkeit eines Ultraschalltransducers entgegensteht.

Durch sogenannte Flip-chip Packages (Feiertag et al., 2010) kann die Bauhöhe der Abdeckungen verringert werden, weil die Bauhöhe der Abdeckungen nicht mehr für Drahtbonds ausgelegt sein müssen. Jedoch ist auch hier der Miniaturisierungseffekt gering.

Die Verwendung von metallisierten Polymerfolien als äußere Packageschicht ist ebenfalls aus Feiertag et al. bekannt. Dafür werden Polymerfolien auf die Oberseite der MEMS-Transducer laminiert und anschließend mit einer Metallschicht versehen. Das Verfahren ist jedoch aufwendig. Außerdem muss die Folie hierfür thermisch verformt und/oder bei der Nacharbeitung/Strukturierung durch Laserablation erhitzt werden, wodurch Temperatur in den MEMS-Transducer eingebracht wird.

Durch Erwärmung werden thermoplastische Kunststoffe leichter verformbar, was bei vergleichbaren Blasformen oder Tiefziehen von Polymeren verwendet wird. Bei all diesen Verfahren wird jedoch zusätzlicher Stress auf das Bauteil ausgeübt. Hierdurch können Spannungen in das Bauteil eingebracht werden oder sonstige Schädigungen sowie unerwünschte Ausgasungen stattfinden. Es ist außerdem schwierig, die Folie allseitig bündig und enganliegend über den MEMS-Transducer zu legen, sodass Undichtigkeiten gegenüber der Packageumgebung entstehen können und die kompakte Bauweise leidet.

US 6,956,283 B1 offenbart ein Verfahren, um Komponenten eines MEMS-Sensors in einem *"package first, release later"*-Ansatz vor äußeren Einflüssen zu schützen. Ein matrixförmiges Array von Mikrospiegeln befindet sich hierbei auf einem Siliziumchip, welche sich wiederrum auf einem Substrat befindet. Bei dem vorgeschlagenen Verfahren wird eine schützende Schicht auf die wesentlichen Komponenten des Sensors aufgetragen. Zur Beschichtung können verschiedene Verfahren zum Einsatz kommen, wie beispielsweise Sprühen oder Vakuumbeschichtungen. Nach dem Abscheiden wird die schützende Schicht über einem aktiven Bereich entfernt. Schließlich wird als Schutzgehäuse ein Deckel aufgebracht.

US 2019/0148566 A1 betrifft ein Herstellungsverfahren eines Halbleitersensorelementes, wobei es sich um einen Druck-, Gas-, oder als kapazitiver Sensor handeln kann. Das Halbleitersensorelement umfasst ein Substrat, worauf sich ein Halbleiterelement befindet, welches über Bonddrähte mit dem Substrat verbunden ist. Eine dielektrische Schicht wird auf das Halbleitersensorelement über ein Verdampfungsverfahren aufgetragen. Durch Laserstrahlen kann die dielektrische Schicht teilweise entfernt werden. Ein Deckel dient zum Schutz des Halbleiterelementes vor äußeren Kräften.

US 2019/0311961 A1 offenbart einen Halbleitersensor, der ein Substrat mit einem daraufliegenden Chip umfasst. Eine Filmschicht wird auf die Komponenten des Halbleitersensors abgeschieden, um diesen beispielsweise vor äußeren Gasen, Flüssigkeiten etc. zu schützen. Die Filmschicht wird bevorzugt über eine Dampfabscheidung und über alle Komponenten des Sensors aufgetragen, die sich innerhalb des Gehäuse befinden. Das Gehäuse beinhaltet eine Öffnung und dient dem Schutz und Träger der Komponenten des Halbleitersensors.

Ein MEMS-Package, welches auf einen starren Deckel oder Gehäuse verzichten kann, ist im Stand der Technik nicht bekannt.

Im Lichte der Nachteile des Standes der Technik besteht somit ein Bedarf an alternativen oder verbesserten Packages sowie Herstellungsverfahren für Packages für MEMS-Elemente, insbesondere MEMS-Transducer.

Aufgabe der Erfindung

Aufgabe der Erfindung ist es ein MEMS-Package sowie ein Verfahren zur Herstellung eines solchen MEMS-Packages bereitzustellen, welche die Nachteile des Standes nicht aufweisen. Insbesondere war es eine Aufgabe der Erfindung ein MEMS-Package zur Verfügung zu stellen, welches sehr kompakt ist, gleichzeitig dem MEMS-Element, beispielsweise einem MEMS-Transducer, hohen Schutz vor Staub, Feuchte, Flüssigkeiten und ESD bietet und die gewünschten funktionellen Eigenschaften, beispielsweise akustischen Eigenschaften im Falle eines MEMS-Transducers, gewährleistet. Das Package soll zudem aufgrund weniger und einfacher Arbeitsschritte besonders einfach und kostengünstig in der Herstellung und tauglich für die Massenproduktion sein.

Zusammenfassung der Erfindung

Die Aufgabe wird durch die Merkmale der unabhängigen Ansprüche gelöst. Bevorzugte Ausführungsformen der Erfindung sind in den abhängigen Ansprüchen beschrieben.

Die Erfindung betrifft ein Herstellungsverfahren für ein MEMS-Package mit mindestens einer Schicht zum Schutz eines MEMS-Elements, umfassend folgende Schritte:

- Bereitstellen eines MEMS-Elements aufweisend mindestens einen MEMS-Interaktionsbereich auf einem Substrat, wobei das MEMS-Element ein MEMS-Bauelement und einen Prozessor auf dem Substrat umfasst und eine elektrische Verbindung zwischen MEMS-Bauelement und Prozessor vorliegt,
- oberflächenkonforme Beschichtung von dem MEMS-Element mit einer dielektrischen Schicht,
- Aufbringen einer elektrisch leitenden Schicht mindestens bereichsweise auf die dielektrische Schicht, wobei die dielektrische Schicht und die elektrisch leitende Schicht sich über das MEMS-Bauelement und den Prozessor erstrecken.

Bevorzugt ist der MEMS-Interaktionsbereich ein wesentlicher funktioneller Bestandteil des MEMS-Elements, welcher vorzugsweise mit einem Medium in gewünschter Weise interagiert. Eine oberflächenkonforme Beschichtung ist insbesondere eine Beschichtung, welche im Wesentlichen direkt und formerhaltend eng an den darunter liegenden Strukturen anliegt.

Im Wesentlichen direkt und enganliegend bedeutet bevorzugt, dass die Beschichtung mehrheitlich direkt aufliegt, jedoch in einigen Bereichen nicht durch Komponenten ausgefüllte Volumina miteinschließt, beispielsweise in Eckbereichen oder unterhalb eines Drahtbonds. Die oberflächenkonforme Beschichtung ist vorzugsweise vollständig oberflächenkonform. Dies bedeutet insbesondere, dass die Schicht nahezu perfekt enganliegend bzw. oberflächenkonform ist und selbst kleinste Strukturen enganliegend beschichtet werden können. Kleinste Strukturen sind vorzugsweise Strukturen mit Abmessungen der Größenordnung maximal 10 Nanometer (nm), maximal 100 nm, maximal 1 Mikrometer ($\mu$m), maximal 10 $\mu$m oder maximal 100 $\mu$m.

Die dielektrische Schicht umfasst bevorzugt mindestens ein Polymer. Diese sind günstig und leicht zu verarbeiten. Ebenso kann es bevorzugt sein, eine Oxid- oder Nitrid-Schicht, als dielektrische Schicht aufzubringen. Zur oberflächenkonformen Beschichtung eignen sich hierzu insbesondere eine physikalische oder chemische Gasabscheidung (PVD und CVD).

In einer bevorzugten Ausführungsform handelt es sich um ein photostrukturierbares Polymer, z. B. durch entsprechende Beimischungen von fotoempfindlichen Komponenten. Insbesondere handelt es sich um einen Fotolack.

Vorteilhaft können die Eigenschaften des Polymers an die Funktionalität eines MEMS-Elementes angepasst werden. Im Falle eines MEMS-Transducers als MEMS-Element kann es beispielsweise bevorzugt sein

die relativen Permittivität $\varepsilon_r$ des Polymers an Hochfrequenzanwendungen des MEMS-Transducers anzupassen. Beispielsweise kann $\varepsilon_r$ so gewählt werden, dass hochfrequente elektro-magnetische Felder abgeschwächt werden.

Eine derartige funktionelle Beschichtung mit einem Dielektrikum ist mit den Verfahren des Standes der Technik nicht möglich und bietet vorteilhaft eine äußerst kompakte Schutzschicht, welche eine elektrische Isolierung und mechanischen Schutz des MEMS-Elements bietet.

In einer bevorzugten Ausführungsform ist das MEMS-Element ausgesucht ist aus der Gruppe: optischer MEMS-Transducer, akustischer MEMS-Transducer, MEMS-Sensor, insbesondere MEMS-Gassensor und/oder MEMS-Filter. Von den Erfindern wurde erkannt, dass das vorgeschlagenen Packaging mittels einer dielektrischen Beschichtung, vorzugsweise mit einem Polymer, zuverlässigen Schutz für eine Reihe verschiedene MEMS-Elementen bieten kann.

Durch die oberflächenforme Beschichtung, beispielsweise durch ein Sprühverfahren mit einem Polymer, kann einerseits äußerst günstig eine hermetische, bauraumoptimierte Schutzschicht aufgebracht werden. Anderseits erlaubt die oberflächenforme Beschichtung, beispielsweise unter Verwendung photostrukturierbarer Polymere eine hohe Flexibilität hinsichtlich einer gezielten Öffnung oder Aussparung der Schutzschicht in einem Interaktionsbereich des MEMS-Elementes.

Der MEMS-Interaktionsbereich meint bevorzugt einen funktionellen Bestandteil des MEMS-Elements, welcher mit einem äußeren Medium in gewünschter Weise interagiert. Im Falle eines akustischen MEMS-Transducer handelt es sich beispielsweise um eine MEMS-Membran. Im Falle eines optischen MEMS-Transducer handelt es sich beispielsweise um einen optischen Emitter.

In beiden Fällen ist es bevorzugt, dass zum einen unmittelbar im Interaktionsbereich des MEMS-Elementes keine Schutzschicht die Interaktion des MEMS-Elementes mit der Umgebung (Schallabgabe oder -aufnahme, Senden bzw. Empfangen optischer Signale) vermindert, während der Schutz der empfindlichen elektronischen Komponenten gewährleistet wird. Das erfindungsgemäße Verfahren erreicht dies durch eine oberflächenforme Beschichtung bevorzugt mittels Auftragens eines Polymers auf einfache und hocheffiziente Weise.

In einer bevorzugten Ausführungsform ist das MEMS-Element ein optischer MEMS-Transducer, wobei der MEMS-Interaktionsbereich einen optischen Emitter und/oder einen optischen Empfänger umfasst.

Ein optischer Emitter kann z. B. ein Oberflächenemitter bzw. VCSEL (*vertical-cavity surfaceemitting laser*) oder eine LED umfassen. Ein optischer Empfänger ist beispielsweise ein Photodiode oder ein Bildsensor.

In einer bevorzugten Ausführungsform kann der optische Emitter ein modulierbarer MEMS-Emitter sein. Beispielsweise kann die Modulation der Intensität des optischen Emitters mittels Blendenstrukturen und MEMS-Aktuatoren erfolgen, beispielsweise einem elektrostatischen Aktuator, einem piezoelektrischen Aktuator, einem elektromagnetischen Aktuator und/oder einem thermischen Aktuator.

In einer bevorzugten Ausführungsform ist das MEMS-Element ein akustischer MEMS-Transducer, wobei der MEMS-Interaktionsbereich eine MEMS-Membran umfasst.

In einer bevorzugten Ausführungsform ist der MEMS-Transducer ein MEMS-Lautsprecher, ein MEMS-Mikrofon und/oder ein MEMS-Ultraschalltransducer. Die MEMS-Membran ist vorzugsweise schwingfähig. Eine Membran ist bevorzugt eine dünne, flächige Struktur mit einem Umfang in z. B. im Wesentlichen runder und/oder polygonaler Ausprägung. Die Membran ist vorzugsweise wenigstens bereichsweise entlang eines des Umfangs schwingbar gelagert.

Begriffe wie im Wesentlichen, ungefähr, etwa, ca. etc. beschreiben bevorzugt einen Toleranzbereich von weniger als $\pm$ 20%, bevorzugt weniger als $\pm$ 10 %, noch stärker bevorzugt weniger als $\pm$ 5% und insbesondere weniger als $\pm$ 1 %. Angaben von im Wesentlichen, ungefähr, etwa, ca. etc. offenbaren und umfassen stets auch den exakten genannten Wert.

Ein MEMS-Lautsprecher oder MEMS-Mikrofon bezeichnet bevorzugt einen Lautsprecher bzw. Mikrofon, welche auf einer MEMS-Technologie basiert und dessen klangerzeugende oder klangaufnehmenden Strukturen mindestens teilweise eine Dimensionierung im Mikrometerbereich (1 $\mu$m bis 1000 $\mu$m) aufweisen. Bevorzugt kann die schwingfähige Membran in Breite, Höhe und/oder Dicke eine Dimension im Bereich von weniger als 1000 $\mu$m aufweisen.

Unter dem Begriff MEMS-Transducer oder MEMS-Wandler ist sowohl ein MEMS-Mikrofon als auch ein MEMS-Lautsprecher zu verstehen. Allgemein bezeichnet der MEMS-Transducer einen Wandler zur Interaktion mit einem Volumenstrom eines Fluids, der auf MEMS-Technologie basiert und dessen Strukturen zur Interaktion mit dem Volumenstrom bzw. zur Aufnahme oder Erzeugung von Druckwellen des Fluids eine Dimensionierung im Mikrometerbereich (1 $\mu$m bis 1000 $\mu$m) aufweisen. Bei dem Fluid kann es sich sowohl um ein gasförmiges, als auch flüssiges Fluid handeln. Die Strukturen des MEMS-Transducer, insbesondere der schwingfähigen Membran sind zur Erzeugung oder Aufnahme von Druckwellen des Fluids ausgelegt.

Beispielsweise kann es sich, wie im Falle eines MEMS-Lautsprechers oder MEMS-Mikrofons, um Schalldruckwellen handeln. Der MEMS-Transducer kann sich aber ebenso als Aktuator oder Sensor für andere Druckwellen eignen. Der MEMS-Wandler ist somit bevorzugt ein Gerät, welches Druckwellen (z.B. akustische Signale als Schallwechseldrücke) in elektrische Signale umwandelt oder umgekehrt (Umwandlung elektrischer Signale in Druckwellen, beispielsweise akustische Signale).

MEMS-Transducer umfassen bevorzugt einen MEMS-Baustein (z. B. MEMS-Chip) mit einer schwingfähigen Membran, dessen Schwingungen beispielsweise durch piezoelektrische oder piezoresistive Komponenten auf bzw. an der Membran erzeugt und/oder ausgelesen werden.

In einer bevorzugten Ausführungsform ist der MEMS-Transducer ein piezoelektrischer MEMS-Transducer.

Ebenso sind kapazitive Methoden zur Erzeugung und/oder Messung von Schwingungen der Membran bekannt.

In einer bevorzugten Ausführungsform ist der MEMS-Transducer ein kapazitiver MEMS-Transducer.

In bevorzugten Ausführungsformen können MEMS-Transducer können auch als MEMS-Ultraschall-Transducer ausgestaltet sein, welche zur Aussendung und/oder zum Empfang von Ultraschall geeignet sind.

Dabei handelt es sich insbesondere um kapazitive mikromechanische Ultraschalltransducer (CMUT), um piezoelektrische mikromechanische Ultraschalltransducer (PMUT) oder um kombinierte Ultraschallransducer (*piecoelectric composite ultrasound transducers*, PC-MUT).

Ultraschall umfasst Frequenzen ab 1 Kilohertz (kHz), typischerweise vor allem ab 16 kHz. Anwendungen von kompakten Ultraschall-Transducern umfassen bildgebende Verfahren, z.B. in der Medizin, aber auch bei der Vermessung sonstiger Objekte. Verwendungen zur Ultraschalldichtemessung, zur Festigkeitsmessung an Beton, Gips und Zement, zur Füllstandsmessung bei flüssigen und festen Medien unterschiedlichster Konsistenz und Oberflächenbeschaffenheit oder für ein Ultraschallmikroskop sind ebenfalls denkbar. Dabei ist es oftmals erwünscht, dass die Membran des Transducers (d.h. des MEMS-Interaktionsbereiches) mit dem zu vermessenden Gegenstand/der zu vermessenden Flüssigkeit in direktem Kontakt steht.

Mit dem erfindungsgemäßen Verfahren zur oberflächen konformen Beschichtung einer dielektrischen Schutzschicht kann dies vorteilhaft erreicht werden, ohne die Schutzfunktionen zu beeinträchtigen. Stattdessen kann auf einfache Weise gezielt, die dielektrische Schutzschicht im Interaktionsbereich entfernt werden, während die Schicht eng an den übrigen Strukturen anliegt. Insbesondere in Bezug auf akustische MEMS-Transducer - wie MEMS-Mikrofone oder MEMS-Lautsprecher - können hierdurch Einflüsse auf das akustische Verhalten vermieden und ausgezeichnete Detektions- bzw. Klangergebnisse erzielt werden.

In einer weiteren bevorzugten Ausführungsform ist das MEMS-Element ein MEMS-Gassensor, wobei der MEMS-Interaktionsbereich eine MEMS-Membran und/oder einen elektro-chemischen MEMS-Sensorbereich umfasst.

Beispielsweise kann es sich um ein photoakustisches Spektroskop mit einem MEMS-Sensor handeln.

Bei der photoakustischen Spektroskopie wird bevorzugt eine intensitätsmodulierte Infrarotstrahlung mit Frequenzen im Absorptionsspektrum eines in einem Gas zu detektierendem Molekül eingesetzt. Ist dieses Molekül im Strahlengang vorhanden, findet eine modulierte Absorption statt, die zu Erwärmungs- und Abkühlungsprozessen führt, deren Zeitskalen die Modulationsfrequenz der Strahlung widerspiegeln. Die Erwärmungs- und Abkühlungsprozesse führen zu Expansionen und Kontraktion des Gases, wodurch Schallwellen mit der Modulationsfrequenz verursacht werden. Diese lassen sich durch Sensoren wie beispielsweise Schalldetektoren oder Flusssensoren messen.

Die Leistung der Schallwellen ist dabei vorzugsweise direkt proportional zur Konzentration des absorbierenden Gases. Ein photoakustisches Spektroskop umfasst daher bevorzugt einen mindestens einen Emitter, einen Detektor und eine Zelle. Bei einem MEMS-Gassensor wird bevorzugt der Detektor als MEMS-Sensor ausgeführt.

Ein MEMS-Sensor kann beispielsweise ein kapazitiv oder optisch auslesbaren, piezoelektrischen, piezoresistiven und/oder magnetischen Balken und/oder ein kapazitives, piezoelektrischen, piezoresistives und/oder optisches Mikrofon bzw. Membran umfassen.

Im Sinne der Erfindung kann der MEMS-Sensor eines photoakustischen Spektroskops bevorzugt als dessen MEMS-Interaktionsbereich aufgefasst werden, da dieser vorzugsweise unmittelbar mit einem Medium in Berührung steht.

In einer weiteren bevorzugten Ausführungsform ist das MEMS-Element ein MEMS-Filter, bevorzugt ein MEMS-Frequenzfilter, insbesondere ein SAW- oder BAW-Filter, wobei der MEMS-Interaktionsbereich eine MEMS-Filterstruktur, insbesondere MEMS-Elektroden und/oder einen MEMS-Bulkbereich umfasst.

Ein SAW-Filter ist bevorzugt ein akustischer-Oberflächenwellen-Filter, (ebenso AOW-Filter), welcher insbesondere einen Bandpassfilter für elektrische Signale darstellt.

Diese basieren vorzugsweise auf Interferenz von Signalen verschiedener Laufzeit und verwenden bevorzugt den Piezoeffekt. Bevorzugt ist auf einem piezoelektrischen Einkristall je ein Paar kammförmig ineinandergreifender Elektroden umfasst, welche vorzugsweise den Interaktionsbereich bilden.

BAW-Filter (engl. *bulk acoustic wave*) sind vorzugsweise ähnliche elektronische Filter mit Bandpass-Charakteristik. Jedoch weisen diese bevorzugt im Gegensatz zum SAW-Filter ein Substrat (Bulk) auf, indem die Ausbreitung der akustischen Wellen erfolgt. Dieses Substrat bzw. dieser Bulkbereich bildet vorzugsweise den MEMS-Interaktionsbereich.

In einer bevorzugten Ausführungsform der Erfindung wird die oberflächenkonforme Beschichtung durch ein Beschichtungsverfahren mit einem Dielektrikum vorgenommen, wobei das Beschichtungsverfahren ausgesucht ist aus der Gruppe: Sprühbeschichtung, Nebelbeschichtung, galvanische Beschichtung und/oder Dampfbeschichtung.

Eine Sprühbeschichtung bezeichnet bevorzugt ein flächiges Aufbringen der dielektrischen Schicht, wobei das Dielektrikum vor dem Sprühen vorzugsweise unter Druck gestellt wird (z.B. größer als der vorherrschende Umgebungsdruck, z. B. bei Atmosphärendruck bevorzugt bei mehr als 1 bar, stärker bevorzugt bei mehr als 2 bar, insbesondere bei 2 - 6 bar), sodass feine Partikel/Aerosole des Dielektrikums und/oder ein Schaum entstehen. Dadurch kann eine besonders feine Beschichtung erreicht werden, welche alle besprühten Bereiche bedeckt, auch wenn diese beispielsweise Flächen aufweisen, welche gegenüber der Sprührichtung in einem ungünstigen Winkel liegen. Auch zueinander abgewinkelte Flächen/Bereiche können so bevorzugt direkt bedeckt werden. Bei Verwendung einer Folie wie im bekannten Stand der Technik, ist es dagegen äußerst schwierig, solche Flächen direkt abzudecken, ohne das unbedeckte Volumina entstehen. Dies liegt z. B. daran, dass die Folie zusammenhängend ist und unter Spannung steht.

Bevorzugt wird für das Beschichtungsverfahren ein flüssiges Dielektrikum unter gegenüber Umgebung erhöhten Druck zerstäubt und flächig aufgebracht.

Die Sprühbeschichtung ist vorzugsweise eine Sprühbelackung.

Die Sprühbeschichtung und/oder oberflächenkonforme Beschichtung kann auch eine Gasphasenabscheidung sein, insbesondere wenn die dielektrische Schicht ein aus der Gas- und/oder Flüssigphase abscheidbares Polymer, z. B. Tetraethylorthosilicat (TEOS) und/oder Parylene umfasst. Dadurch kann eine besonders enganliegende bzw. oberflächenkonforme Beschichtung auf den Transducerkomponenten erreicht werden.

Eine Nebelbeschichtung umfasst vorzugsweise eine Beschichtung durch feine Tröpfchen des Dielektrikums, welcher in einer Atmosphäre (bevorzugt ein Gas) fein verteilt sind. Durch eine Nebelbeschichtung ist bevorzugt eine vollständig oberflächenkonforme Beschichtung erreichbar.

Eine Dampfbeschichtung erfolgt vorzugsweise durch ein aufzutragendes Dielektrikum in Dampfform, bzw. gasförmig. Eine Dampfbeschichtung kann beispielsweise eine PVD (*physical vapour deposition,* zu deutsch physikalische Gasabscheidung) oder eine CVD (*chemical vapour deposition,* zu deutsch chemische Gasabscheidung) umfassen. Durch eine Dampfbeschichtung ist vorteilhafterweise eine vollständig oberflächenkonforme Beschichtung eines Dielektrikums möglich.

In einer bevorzugte Ausführungsform erfolgt die oberflächenkonforme Beschichtung durch Auftragen einer dielektrischen Schicht mittels einer physikalischen Gasabscheidung (PVD) oder einer chemischen Gasabscheidung (CVD).

In einer bevorzugten Ausführungsform ist die dielektrische Schicht eine Oxid- oder Nitrid-Schicht, welche bevorzugt mittels einer physikalischen oder einer chemischen Gasabscheidung (CVD) aufgetragen wurde.

Bei einer Oxid- oder Nitridschicht kann es sich beispielsweise um eine Schicht eines Metall- oder Halbmetalloxid bzw. ein Metall- oder Halbmetallnitrid handeln.

In einer bevorzugten Ausführungsform ist die dielektrische Schicht eine Schicht umfassend ein Aluminiumnitrid, Siliziumnitrid, Aluminiumoxid, Siliziumdioxid, Titandioxid und/oder Tantaloxid. Auch eine galvanische Beschichtung kann von der oberflächenkonformen Beschichtung umfasst sein. Unter einer galvanischen Beschichtung wird bevorzugt eine elektrochemische Abscheidung von Überzügen auf Substrate (vorliegend dem MEMS-Element) bezeichnet.

In einer bevorzugten Ausführungsform erfolgt die oberflächenkonforme Beschichtung durch eine zumindest bereichsweise das MEMS-Element benetzende Beschichtung.

Benetzend bedeutet bevorzugt vollständig benetzend oder im Wesentlichen vollständig benetzend. Vollständig benetzend bedeutet bevorzugt, dass das Dielektrikum, welches vorzugsweise in flüssiger Form aufgebracht wird, sich auf der Oberfläche in Form einer flachen Scheibe ausbreitet. Es ist insbesondere kein makroskopischer Kontaktwinkel vorhanden. Bevorzugt handelt es sich um einen im Wesentlichen nahezu monomolekularen Film mit einem Kontaktwinkel von Null.

Vorzugsweise beschreibt der Spreizparameter S die Differenz zwischen der Oberflächenspannung des Substrats (GS), der Oberflächenspannung der Flüssigkeit (GL) und der Grenzflächenspannung zwischen Substrat und Flüssigkeit (GSL). Mit diesem kann bevorzugt zwischen vollständiger und partieller Benetzung unterschieden werden:

$$S = GS - GL - GSL$$

Ist S > 0 benetzt das Dielektrikum das Substrat vollständig. Der Fall S < 0 charakterisiert die partielle Benetzung.

Bevorzugt bedeutet vollständig benetzend S > 0.

In einer bevorzugten Ausführungsform sind Dielektrikum, Beschichtungsverfahren und/oder eine Oberfläche des MEMS-Elements (zumindest bereichsweise) konfiguriert für die benetzende Beschichtung.

Wie genau die Materialien, die Tröpfchengröße des Dielektrikums, die Rauigkeit einer Oberfläche etc. gewählt werden müssen, um eine gewünschte Benetzung zu erhalten weiß der Fachmann. Es können z. B. Ansätze gemäß Härth et al., 2012 verfolgt werden, um die relevanten Größen zu berechnen.

In einer bevorzugten Ausführungsform erfolgt die oberflächenkonforme Beschichtung durch eine zumindest in Bereichen das MEMS-Element entnetzende Beschichtung, wobei die Bereiche vorzugsweise den MEMS-Interaktionsbereich umfassen.

Besonders bevorzugt erfolgt die oberflächenkonforme Beschichtung durch eine zumindest bereichsweise das MEMS-Element benetzende Beschichtung, wobei im MEMS-Interaktionsbereich eine entnetzende Beschichtung erfolgt.

Entnetzend bedeutet bevorzugt, dass das Dielektrikum sich auf der Oberfläche zu einem im Wesentlichen kugelförmigen Tropfen zusammenzieht und/oder einen Kontaktwinkel größer 90° aufweist. Bei einer leichten Neigung der Oberfläche gleitet der Tropfen bevorzugt ohne jegliche Flüssigkeitsrückstände herunter, insbesondere perlt die Flüssigkeit (das Dielektrikum) ab. Bevorzugt weist das Dielektrikum beim Aufbringen auf die Oberfläche einen Kontaktwinkel von im Wesentlichen 180° auf und der Flüssigkeitstropfen berührt den Feststoff im Wesentlichen nur an einem Punkt. So kann das Dielektrikum besonders einfach nach der Beschichtung vom MEMS-Interaktionsbereich entfernt werden.

In einer bevorzugten Ausführungsform der Erfindung sind Dielektrikum, Beschichtungsverfahren und/oder Bereiche der Oberfläche des MEMS-Elements, bevorzugt des MEMS-Interaktionsbereiches, konfiguriert für eine entnetzende Beschichtung.

Dabei spielen bevorzugt die gleichen Überlegungen eine Rolle, wie bei der benetzenden Beschichtung. Hinsichtlich der Wahl der Tröpfchengröße des Dielektrikums, der Rauigkeit einer Oberfläche etc. kann der Fachmann sich an bekannten Ansätzen der Fachliteratur orientieren (vgl. u.a. Härth et al., 2012).

In einer bevorzugten Ausführungsform umfasst die dielektrische Schicht und/oder das Dielektrikum ein Polymer oder eine Polymermischung.

Polymere bezeichnen bevorzugt eine chemische Verbindung, aus Ketten- oder verzweigten Molekülen (Makromolekül), welche aus gleichen oder gleichartigen Einheiten (den sogenannten Monomeren) bestehen.

Nicht-beschränkende Beispiele von Polymeren sind Polymethylmethacrylate (PMMAs), Poly(methylmethacrylat- co- methacrylsäure) (PMMA co MA), Poly( $\alpha$ -methylstyren- cochlormethacrylsäuremethylester) (PMS co CI-MMA), Polystyrene (PS), Polyhydroxystyrene (PSOH), Poly(hydroxystyren- co- methylmethacrylat) (PSOH co MMA), Phenolharze, besonders bevorzugt Polyimide (PI) oder auch Parylene.

Aufgrund der leichten Verarbeitung und formanliegenden Beschichtungsmöglichkeit, sind Polymere für die dielektrische Beschichtung besonders geeignet.

In einer bevorzugten Ausführungsform ist das Polymer für die Beschichtung des MEMS-Elementes mit einer dielektrischen Schicht ein photostrukturierbares Polymer oder eine photostrukturierbar Polymermischung. Photostrukturierbar bedeutet bevorzugt durch Licht-, Elektronen und/oder Ionenstrahlung strukturierbar.

Die dielektrische Schicht kann besonders einfach durch eine Polymerbeschichtung, bevorzugt mittels eines photostrukturierbaren Polymer oder einer photostrukturierbaren Polymermischung gebildet werden. Ein photostrukturierbarer Polymer oder Polymermischung bezeichnet bevorzugt eine Beschichtung, welche durch Belichtung (Bestrahlung mit elektromagnetischer Strahlung) verändert werden kann, um durch nachträgliches Herauslösen von bestimmten Bereichen in Abhängigkeit der erfolgten Bestrahlung eine Struktur zu erhalten.

Eine Polymermischung kann beispielsweise durch entsprechende Beimischungen von fotoempfindlichen Komponenten photostrukturierbar gehalten werden. Besonders bevorzugt handelt es sich bei einem photostrukturierbaren Polymer oder einer photostrukturierbaren Polymermischung um einen Fotolack.

Dies erlaubt vorteilhaft das nachträgliche Entfernen einer dielektrischen Schicht, beispielsweise in einem MEMS-Interaktionsbereich mittels optischer Methoden. Ein bereichsweises Entfernen einer dielektrischen Schicht ist besonders einfach, wenn in dieser ein photostrukturierbares Polymer umfasst ist und lithographische Verfahren zur Anwendung kommen.

In einer bevorzugten Ausführungsform der Erfindung erfolgt die oberflächenkonforme Beschichtung von dem MEMS-Element mit einer dielektrischen Schicht durch eine oberflächenkonforme Beschichtung mit einem Fotolack (engl. *photo resist*).

Fotolacke bzw. Fotolackzusammensetzungen (engl. *photo resist*) sind dem Fachmann hinlänglich bekannt und werden insbesondere bei der Fotolithographie eingesetzt.

Die Strukturierung eines Fotolackes umfasst in der Regel mehrere Schritte, einschließlich der Belichtung des Fotolackes mit einer ausgewählten Lichtquelle durch eine geeignete Maske, um ein latentes Bild der Maske aufzuzeichnen, und der anschließenden Entwicklung und Entfernung ausgewählter Bereiche des Fotolackes. Bei einem "positiven" Fotolackes werden die belichteten Bereiche transformiert, um die Bereiche selektiv entfernbar zu machen; während bei einem "negativen" Fotolack die belichteten Bereiche stabilisiert werden, während die unbelichteten Bereiche entfernbar sind.

Eine negativer Fotolack kann vorzugsweise durch Belichtung und einen nachfolgenden Ausheizschritt polymerisiert werden, sodass der Bereich unlöslich gegenüber einem Fotolack-Entwickler wird. Nach einer der Entwicklung bleiben somit nur die belichteten Bereiche stehen. Die unbelichteten Bereiche werden hingegen durch den Fotolack-Entwickler aufgelöst.

Im Gegensatz dazu ist ein positiver Fotolack dadurch gekennzeichnet, dass bestrahlte Bereiche löslich gegenüber einem Fotolack-Entwickler werden. Die unbelichteten Bereiche des Fotolackes verbleiben hingegen unlöslich und bleiben somit auch nach einer Entwicklung bestehen.

Positive Fotolacke können beispielsweise ein Polymerharz (z.B. Novolak) zusammen mit einer fotoaktiven Komponente (z. B. eine polymere Diazoverbindung) und ein Lösungsmittel umfassen. Als Novolake werden bevorzugt Phenolharze bezeichnet, die mit einem Formaldehyd-Phenol-Verhältnis kleiner als 1:1, durch saure Kondensation von Methanal und Phenol erhalten werden können. Nach der Beschichtung, vorzugsweise als Flüssigkeit, können positive Fotolack ausgeheizt werden (engl. *pre-bake*). Dabei entweicht vorzugsweise das Lösungsmittel und der Fotolack härtet aus. Bei einer Belichtung des Fotolackes z.B. mittels UV-Licht kann der Lack strukturiert werden, in dem gezielt an den bestrahlten Bereichen die fotoaktive Komponente die stoffliche Bindung im Lack aufbricht. An den belichteten Stellen wird der Lack löslich. Nach der Belichtung werden diese Bereiche mit einer geeigneten Fotolack-Entwicklerlösung weggespült und es bleiben die unbelichteten Teile des Fotolacks stehen. Durch ein erneutes Ausheizen (engl. *hard-bake*) kann die Fotolackmaske zusätzlich stabilisiert werden.

Als Fotolacke sind beispielsweise Polymerharzmaterialien bekannt, welche mittels einer Bestrahlung aktiviert werden können.

Polymerharzmaterialien enthalten typischerweise ein oder mehrere in wässriger Basis lösliche Polymere (vgl. obig beschrieben Polymere wie PMMA oder PI). Ein beispielhafter Polymerharz ist Novolak.

Um eine Photostrukturierbarkeit zu erhalten sind den Fotolacken bevorzugt photosensitive Komponenten, wie beispielsweise Naphthochinondiazide oder eine polymere Diazoverbindung, wie Diazonaphthoquinone (DNQ), zugesetzt.

Fotolacke werden als Lösung verarbeitet, wobei geeignete Lösungsmittel dem Fachmann bekannt sind und beispielhaft 1-Methoxy-2-propyl-acetat (PMA), Ethyllactat, Butyrolacton Ether, Glykolether, aromatische Kohlenwasserstoffe, Ketone, Ester und andere ähnliche Lösungsmittel sein können.

Zudem können Fotolacke weiter Komponenten, wie Tenside, Basen, Säurebildner oder Vernetzer umfassen. Insbesondere die Strukturierung von Negativlacken beruht auf der Stabilisierung belichteter Bereiche unter Einsatz von Vernetzern (cross linker). Radikalstarter, wie z.B. Azo-bis(isobutyronitril) (AIBN) oder Dibenzoylperoxid (DBDO), bilden durch Erwärmen oder auch einer Bestrahlung (bevorzugt kurzwelliges Licht < 300nm) reaktiver Radikale, wird als Folge einer ausgelösten Kettenreaktionen eine Vernetzung der Polymermatrix bewirkt.

Daraus resultiert eine Verringerung der Löslichkeit in den eingesetzten organischen Fotolack-Entwicklern (z.B. MIBK-Entwickler). Die belichteten Bereiche bleiben daher nach einer Entwicklung stehen. Säurebildner können nach erfolgter Aktivierung durch Reaktion mit beigefügten aminischen Komponenten (Cymel) crosslinken.

In bevorzugten Ausführungsformen kann ein Fotolack ein Polymer und frei ausgewählte Zusatzstoffe zur Vermittlung der gewünschten Funktion umfassen. Beispielhafte wahlweise einsetzbare Hilfsstoffe beinhalten einen fotochemischen Säurebildner, einen thermischen Säurebildner, einen Säureverstärker, einen fotochemischen Basenbildner, einen thermischen Basenbildner, eine fotochemisch abbaubare Base, ein Tensid, ein organisches Lösemittel, einen Basenstopper, einen Sensibilisator und Kombinationen der obigen Hilfsstoffe.

Derartige Fotolacke sind im Stand der Technik hinreichend bekannt. Erfindungsgemäß wurde jedoch erkannt, dass diese sich vorteilhaft, wie beschrieben, für eine oberflächen konforme Beschichtung als dielektrische Schutzschicht für ein MEMS-Package eignen.

In einer bevorzugten Ausführungsform umfasst die dielektrische Schicht und/oder das Dielektrikum ein Polymethylmethacrylat, eine Polyimid (PI), Novolak, Polymethylglutarimid, aus der Gas- und/oder Flüssigphase abscheidbare Polymere, insbesondere Tetraethylorthosilicat (TEOS) und/oder Parylene und/oder Epoxidharz, insbesondere SU-8.

Die Verwendung von Polymeren zur Bereitstellung der dielektrischen Schutzschicht mittels eines Beschichtungsverfahrens ermöglicht vorteilhaft eine besonders oberflächenkonforme Beschichtung, welche eine formschlüssige Beschichtung sämtlicher Bauteile ermöglicht. Hierbei können beispielsweise eine Sprüh-/oder Gasphasenabscheidung eingesetzt werden.

Vorteilhaft können auch kleinste Strukturen des MEMS-Elements zuverlässig hermetisch abgedeckt werden. Auf einen zusätzlichen Schutz von z.B. Bonddrähten im Falle einer konventionellen Chipbauweise kann verzichtet werden. Auch keine weiteren Verfahren zum Unterfüllen von Flipchip-Bauteilen werden benötigt.

Zudem kann mittels einer Polymerbeschichtung die Funktionalität der dielektrischen Schicht auf das MEMS-Element abgestimmt werden.

Beispielsweise kann es bevorzugt sein, die relativen Permittivität $\varepsilon_r$ des Polymers an Hochfrequenzanwendungen eines MEMS-Transducers anzupassen. Hierbei kann $\varepsilon_r$ bevorzugt so gewählt werden, dass hochfrequente elektro-magnetische Felder zuverlässig abgeschwächt werden.

Auch kann es bevorzugt sein, verschiedene Polymere aufeinander abzuscheiden, um z.B. einen Gradienten in der Permittivität für Hochfrequenzbauteile zu erzeugen, oder die dielektrische Schicht bezüglich der optischen Eigenschaften zu optimieren, insbesondere wenn das MEMS-Bauelement ein mikrooptoelektromechanische (MOEMS) Bauteil umfasst oder von diesem umfasst ist.

Mittels eines oberflächenkonformen Beschichtungsverfahrens, insbesondere unter Verwendung von Polymeren, kann eine hochfunktionelles und äußerst kompakt MEMS-Package auf einfache Weise bereitgestellt werden, welches gleichzeitig einen vollwertigen Schutz der empfindlichen Strukturen von MEMS-Elementen, z.B. MEMS-Transducern, bietet.

In einer bevorzugten Ausführungsform umfasst das Herstellungsverfahren zusätzlich folgenden Schritt:

- Aufbringen einer elektrisch-leitenden Schicht mindestens bereichsweise auf die dielektrische Schicht.

Das Aufbringen einer elektrisch-leitenden Schicht mindestens bereichsweise auf die dielektrische Schicht bewirkt vorteilhafterweise, dass das so entstandene Schichtsystem im Wesentlichen enganliegend ist und den MEMS-Transducer vor Kurzschlüssen und elektrostatischen Entladungen schützt sowie gegenüber Flüssigkeiten und/oder Luft abdichtet. Auch ein mechanischer Schutz wird vorzugsweise verbessert.

Die elektrisch leitende Schicht ist insbesondere ein Metall, welches dem MEMS-Elements mechanischen Schutz bietet und vor dem Eindringen von Luft, Feuchte, Flüssigkeiten, Staub in das Innere des Packages schützt. Insbesondere ist eine Metallbeschichtung hermetisch.

Durch Aufbringen einer elektrisch leitenden Schicht - vorzugsweise einer Metallschicht - über der dielektrischen Schicht kann zudem ein mechanisch stabiler Abschluss gewährleistet werden, welcher neben dem Eindringen von Luft, Feuchte, Flüssigkeiten auch äußeren Kräften widerstehen kann. Ein Schichtsystem aus einer Metallschicht auf einer dielektrischen Schicht weist somit eine besonders wirksame Gehäusefunktion auf, sodass auf separate Deckel oder Gehäuse verzichtet werden kann. Vorteilhaft gewährleistet das Schichtsystem zudem einen guten akustische Abschluss und führt im Falle eines Einsatzes bei einem MEMS-Lautsprecher oder MEMS-Mikrofon zu sehr guten Detektions- bzw. Klangergebnissen.

In einer bevorzugten Ausführungsform ist umfasst die elektrisch leitende Schicht ein Metall, vorzugsweise Aluminium und/oder ein Edelmetall, bevorzugt Gold, Platin, Iridium, Palladium, Osmium, Silber, Rhodium und/oder Ruthenium.

Die elektrisch leitende Schicht wird bevorzugt aufgebracht bzw. abgeschieden. Die elektrisch leitende Schicht stellt bevorzugt eine metallische Schicht, besonders bevorzugt einen metallischen Film, insbesondere einen metallischen Dünnfilm dar.

In einer bevorzugten Ausführungsform wird die elektrisch leitende Schicht durch ein Beschichtungsverfahren, insbesondere durch ein PVD-, CVD- und/oder ein Sputterverfahren aufgebracht.

Vorzugsweise lappt die dielektrische Schicht an den äußeren Rändern der dielektrischen Schicht über. Solche äußeren Ränder befinden sich beispielsweise auf der Oberseite des Substrats, wo die dielektrische Schicht endet. Da bedeckt die elektrisch leitende Schicht vorzugsweise allseitig den Randbereich und reicht bis auf das Substrat. Durch einen solchen Überlapp kann die Dichtigkeit des Packages verbessert werden.

Das so hergestellte Schichtsystem ist äußerst kompakt und einfach herzustellen, bietet jedoch vollwertigen Schutz des MEMS-Elementes, beispielsweise eines MEMS-Transducers. Durch eine oberflächenkonforme Beschichtung, z.B. eine Sprühbeschichtung, kann eine allseitig enganliegende Beschichtung erreicht werden, welche zur Kompaktheit und Dichtigkeit gegenüber der Packageumgebung beiträgt.

Ein solches Enganliegen kann durch eine Folie nicht erreicht werden. Außerdem sind im Gegensatz zur Folie keine zusätzlichen und aufwendigen Arbeitsschritte nötig, welche darüber hinaus u. U. das MEMS-Element beeinflussen.

Vorteilhaft kann eine elektrisch leitende Schicht direkt auf die dielektrische Schicht aufgebracht werden. Das Schichtsystem kann optisch eindeutig von Folienpackages unterschieden werden, bspw. durch die Feinheit der Schicht (messbare Rauigkeit) und das direkte Aufliegen auf den darunter befindlichen Komponenten. Auch erlaubt die Sprühbeschichtung im Gegensatz zu Packages auf Folienbasis auch die Abdeckung von Drahtbonds, da sich die Sprühschicht vorteilhafterweise einfach über den/die Drahtbond(s) legt, ohne eine nennenswerte Kraft auf den Drahtbond auszuüben, welche diesen zerstören könnte.

Erfindungsgemäß umfasst das MEMS-Element ein MEMS-Bauelement und einen Prozessor, bevorzugt eine integrierte Schaltung auf dem Substrat, und eine elektrische Verbindung zwischen MEMS-Bauelement und dem Prozessor, bevorzugt der integrierten Schaltung. Hierbei erstreckt sich die dielektrische Schicht sowie die elektrisch leitende Schicht (vorzugsweise eine Metallschicht) über das MEMS-Element und den Prozessor und optional über die elektrische Verbindung zwischen MEMS-Bauelement und dem Prozessor. Durch das Schichtsystem kann somit gleichzeitig ein vollständiger Schutz sowohl der sensitiven mikromechanischen Komponenten, als auch der elektronischen Komponenten bzw. des Prozessors erreicht werden. Ein separates Gehäuse, welches Prozessor und MEMS-Bauelement einschließt und schützt ist nicht notwendig.

Im Sinne der Erfindung bezeichnet der Begriff Prozessor bevorzugt einen logischen Schaltkreis, welcher Daten oder elektrische Signale senden, empfangen und verarbeiten kann. Bevorzugte Prozessoren umfassen ohne Beschränkung eine integrierte Schaltung (IC), ein Anwendungsspezifische integrierte Schaltungen (ASIC), ein Field Programmable Gate Array (FPGA), ein Mikroprozessor, ein Mikrocomputer, eine speicherprogrammierbare Steuerung, und/oder eine sonstige elektronische, bevorzugt programmierbare, Schaltung. Das Substrat kann beispielsweise ausgewählt sein aus einer Gruppe umfassend Silizium, monokristallines Silizium, Polysilizium, Siliziumdioxid, Siliziumcarbid, Siliziumgermanium, Siliziumnitrid, Nitrid, Germanium, Kohlenstoff, Galliumarsenid, Galliumnitrid und/oder Indiumphosphid.

In einer bevorzugten Ausführungsform sind MEMS-Element und/oder Prozessor in einer Flip-Chip Bauweise montiert und vorzugsweise erfolgt die elektrische Verbindung über das Substrat, insbesondere durch Leiterbahnen im Substrat.

Dabei kann die oberflächenkonforme Beschichtung vorzugsweise so vorgenommen werden, dass diese zwar das MEMS-Element zwischen sich und Substrat zumindest bereichsweise einschließt und das MEMS-Element so vorzugsweise elektrisch isoliert und/oder mit der dielektrischen Beschichtung chemisch geschützt wird, jedoch bevorzugt gleichzeitig nicht der Spalt zwischen MEMS-Element (unterhalb MEMS-Element) und Substrat mit einem Dielektrikum mit hohem $\varepsilon_r$ aufgefüllt wird. Dies kann besonders vorteilhaft für Hochfrequenzanwendungen sein.

In einer bevorzugten Ausführungsform der Erfindung sind MEMS-Element und/oder Prozessor, vorzugsweise integrierte Schaltung, nicht in einer Flip-Chip Bauweise montiert und vorzugsweise erfolgt die elektrische Verbindung über mindestens einen Drahtbond.

Auch erlaubt die oberflächenkonforme Beschichtung, beispielsweise eine Sprühbeschichtung mit einem Polymer, im Gegensatz zu Packages auf Folienbasis auch die Abdeckung von Drahtbonds, da sich die Beschichtung vorteilhafterweise direkt über den/die Drahtbond(s) legt, ohne eine nennenswerte Kraft auf den Drahtbond auszuüben, welche diesen zerstören könnte.

Gespannte Folien dagegen zerstören oftmals Drahtbonds, so dass diese Art Package in der Regel nur bei Flip-Chip Packages eingesetzt werden kann. Das durch das hier beschriebene Verfahren entstandene Package ist hingegen formschlüssig mit den eingepackten Strukturen, ohne diese unter nennenswerte Spannung zu setzen. Auch dadurch können die hier beschriebenen Packages bei der Verwendung von Drahtbonds von anderen Packages unterschieden werden. Drahtbonds sind z.B. von außen noch sichtbar, obwohl diese vom Schichtsystem eingeschlossen und geschützt sind. Generell ist bei diesen Packages die Struktur des MEMS-Elements auch von außen durch die Packageschicht sichtbar.

In einer bevorzugten Ausführungsform der Erfindung umfasst das Herstellungsverfahren folgende Schritte:

- Bereitstellen des MEMS-Elements aufweisend einen MEMS-Interaktionsbereich auf dem Substrat
- Oberflächenkonforme Beschichtung, insbesondere Sprühbeschichtung von MEMS-Element, sodass das MEMS-Element vollständig zwischen dielektrischer Schicht und Substrat umfasst ist
- Aufbringen einer elektrisch-leitenden Schicht mindestens bereichsweise auf die dielektrische Schicht, welche mit der dielektrischen Schicht eir Schichtsystem bildet.
- Optional Anordnung einer Öffnung oberhalb des Interaktionsbereichs durch zumindest bereichsweises Entfernen der dielektrischen Schicht und/oder des Schichtsystems oberhalb des Interaktionsbereichs.

In einer bevorzugten Ausführungsform der Erfindung ist die Anordnung der dielektrischen Schicht, des Schichtsystems des MEMS-Elements und/oder des MEMS-Interaktionsbereiches dergestalt, dass nach Entfernen der dielektrischen Schicht oder des Schichtsystems keine elektrisch leitenden Bereiche in direktem Kontakt mit einer Packageumgebung stehen. Insbesondere sind diese gegenüber Luft und/oder Flüssigkeit abgedichtet.

Durch das bereichsweise Entfernen der dielektrischen Schicht und/oder des Schichtsystems, umfassend dielektrische Schicht und elektrisch leitfähiger Schicht kann die Wechselwirkung des Interaktionsbereichs mit dem gewünschten Medium, insbesondere mit der Packageumgebung, verbessert werden.

Im Falle eines akustischen MEMS-Transducer handelt es sich bei dem MEMS-Interaktionsbereich beispielsweise um eine MEMS-Membran, welche zur Aufnahme oder Erzeugung von Schalldruckwellen mit der Packageumgebung wechselwirkt.

Im Falle eines optischen MEMS-Transducer kann es sich bei dem MEMS-Interaktionsbereich, beispielsweise um einen optischen Emitter oder Empfänger handelt, welcher durch Emission oder Empfang elektromagnetischer Strahlung mit der Packageumgebung interagiert.

In beiden Fällen ist es bevorzugt, dass zum einen unmittelbar im Interaktionsbereich des MEMS-Elementes keine dielektrische Schicht oder elektrisch leitfähige Schicht die Interaktion des MEMS-Elementes mit der Umgebung (Schallabgabe, optische Signale) vermindert.

Durch ein bereichsweises Entfernen der des Schichtsystems und/oder des dielektrischen Schicht, beispielsweise unter Verwendung photostrukturierbarer Polymere kann eine ungehinderte Wechselwirkung des MEMS-Elementes in dessen funktionellen Bereich erreicht werden, während der Schutz der gesamten elektronischen Anordnung zuverlässig gewährleistet werden kann.

Das MEMS-Element umfasst bevorzugt ein MEMS-Bauelement aufweisend eine MEMS-Membran für einen MEMS-Transducer. Ein so hergestellte MEMS-Package kann bevorzugt auch als ein MEMS-Transducer Package bezeichnet werden. Ein bevorzugter MEMS-Transducer ist ein akustischer MEMS-Transducer, insbesondere ein PMUT, CMUT und/oder ein PCMUT.

Bevorzugt ist das Schichtsystem ein oberflächenkonformes Schichtsystem bezüglich beschichteter Komponenten des MEMS-Elementes (z. B: MEMS-Bauelement, integrierte Schaltung und bevorzugt elektrischer Verbindung (insbesondere Drahtbond)).

Die Sprühbeschichtung wird bevorzugt so vorgenommen, dass das MEMS-Element vollständig zwischen dielektrischer Schicht und Substrat umfasst ist. Insbesondere sollen keine elektrisch-leitenden/bzw. elektrisch funktionelle Bereiche des MEMS-Elements gegenüber einer Packageumgebung freiliegen, sodass vor allem Kurzschlüsse vermieden werden. Alle elektrischen bzw. elektrisch leitenden Komponenten sollen vorzugsweise bedeckt sein.

Insbesondere sollen der Prozessor, vorzugsweise die integrierte Schaltung (IC), freiliegende elektrische Leitungen, sowie elektrisch funktionelle bzw. leitende Bereiche des MEMS-Elements bedeckt sein. Eine solche dielektrische Schicht bietet vorteilhaft eine Basis für die darauffolgende elektrisch leitende Schicht. Die dielektrische Schicht verhindert, dass die elektrisch leitende Schicht Kurzschlüsse am MEMS-Element verursacht. Die elektrisch leitende Schicht selbst bietet wiederum eine elektrische Abschirmung des MEMS-Elements. Weiterhin kann die elektrische leitenden Schicht, sofern beispielsweise von einem Metall gebildet, zusätzlichen mechanischen Schutz bieten und das Eindringen von Luft, Feuchte, Flüssigkeiten, Staub in das Innere des Packages vermeiden.

Das Schichtsystem stellt mithin eine besondere zuverlässige Barriere dar, welche neben einem mechanischen Schutz ein Permeation von potentiell schädigenden äußeren Einflüssen, wie z.B. Wasserdämpfen, Staub etc. vermeidet.

Die elektrisch-leitenden Schicht wird vorzugsweise mindestens bereichsweise auf die dielektrische Schicht aufgebracht. Vorzugsweise bedeckt die die elektrisch-leitende Schicht die dielektrische Schicht komplett. Jedoch kann die elektrisch-leitende Schicht beim Aufbringen bereits so vorstrukturiert werden, dass ein Bereich, in dem später eine Schallöffnung erzeugt werden soll, bereits ausgespart wird. Dann muss später nur die dielektrische Schicht entfernt werden. Das Entfernen der dielektrischen Schicht ist besonders einfach, wenn in dieser ein photostrukturierbares Polymer umfasst ist und lithographische Verfahren zur Anwendung kommen.

Beispielsweise könnte die elektrisch leitende Schicht (z. B. metallische Schicht) mit einer Schattenmaske vorstrukturiert werden und bevorzugt als Hardmaske für die anschließende Lithografie (z. B zur Erzeugung der Schallöffnung) nutzen.

Das Aufbringen einer elektrisch-leitenden Schicht mindestens bereichsweise auf die dielektrische Schicht bewirkt vorteilhafterweise, dass das so entstandene Schichtsystem im Wesentlichen enganliegend ist und das MEMS-Element vor Kurzschlüssen und elektrostatischen Entladungen schützt sowie gegenüber Flüssigkeiten und/oder Luft abdichtet. Im Wesentlichen enganliegend bedeutet bevorzugt, dass die Beschichtung mehrheitlich direkt aufliegt, jedoch in einigen Bereichen nicht durch Komponenten ausgefüllte Volumina miteinschließt, beispielsweise in Eckbereichen oder unterhalb eines Drahtbonds. Ist die Sprühbeschichtung eine Gasphasenabscheidung, ist mindestens die dielektrische Schicht, vorzugsweise beide Schichten perfekt enganliegend bzw. oberflächenkonform.

Die Sprüh- /oder Gasphasenabscheidung ermöglicht vorteilhafterweise eine formschlüssige Beschichtung der Bauteile. Es werden ggf. keine weiteren Verfahren zum Unterfüllen von Flipchip-Bauteilen und kein zusätzlicher Schutz von z.B. Bonddrähten benötig.

In einer bevorzugten Ausführungsform der Erfindung erfolgt das Entfernen des Schichtsystems oder der dielektrischen Schicht durch lithographische Verfahren, wobei insbesondere eine Vorstrukturierung der dielektrischen Schicht durch entsprechende Belichtung des photostrukturierbaren Polymers vorgenommen wird.

Es kann vorzugsweise eine Foto-, Elektronenstrahl- und/oder Ionenstrahllithographie vorgenommen werden.

Vorzugsweise erfolgt ein solches Entfernen schichtweise. Insbesondere für die dielektrische Schicht kann dieser Prozess vereinfacht werden, wenn ein photostrukturierbares Polymer umfasst ist.

Ein Ätzprozess kann beispielsweise durch Trockenätzen oder nass-chemisch erfolgen.

Ein solcher Prozess ist besonders einfach, schnell und kostengünstig realisierbar.

In einer weiteren bevorzugten Ausführungsform der Erfindung erfolgt das Entfernen des Schichtsystems durch ein Lift-off-Verfahren, wobei insbesondere eine Vorstrukturierung der dielektrischen Schicht durch entsprechende Belichtung des photostrukturierbaren Polymers vorgenommen wird. Das Lift-off-Verfahren wird insbesondere verwendet, um das gesamte Schichtsystem im Bereich der Schallöffnung zu entfernen. Es ist z. B. möglich, die Schichten so vorzustrukturieren, dass sowohl Metall- als auch Polymerschicht in einem Lift-off Schritt entfernt werden können, bspw. wenn die Lift-off-Lackschicht (insbesondere die dielektrische Schicht) an der zu entfernenden Stelle dick genug bzw. dicker als in anderen Bereichen ist.

In einer bevorzugten Ausführungsform beträgt die Schichtdicke der dielektrischen Schicht zwischen 10 nm und 1 mm. Auch Zwischenbereiche aus den vorgenannten Bereichen können bevorzugt seien, wie beispielsweise 10 nm bis 100 nm, 100 nm bis 200 nm, 200 nm bis 500 nm, 500 nm bis 1 $\mu$m, 1 $\mu$m bis 5 $\mu$m, 5 $\mu$m bis 10 $\mu$m, 10 $\mu$m 50 $\mu$m, 50 $\mu$m bis 100 $\mu$m, 100 $\mu$m bis 500 $\mu$m oder auch 500 $\mu$m bis 1 mm. Ein Fachmann erkennt, dass die vorgenannten Bereichsgrenzen auch kombiniert werden können, um weitere bevorzugte Bereich zu erhalten, wie beispielsweise 100 nm bis 1 $\mu$m, 500 nm bis 5 $\mu$m oder 200 nm bis 10 $\mu$m.

In einer bevorzugten Ausführungsform beträgt die Schichtdicke der elektrischen leitenden Schicht zwischen 10 nm und 20 $\mu$m. Auch Zwischenbereiche aus den vorgenannten Bereichen können bevorzugt seien, wie beispielsweise 10 nm bis 100 nm, 100 nm bis 200 nm, 200 nm bis 500 nm, 500 nm bis 1 $\mu$m, 1 $\mu$m bis 5 $\mu$m, 5 $\mu$m bis 10 $\mu$m oder auch 10 $\mu$m bis 20 $\mu$m. Ein Fachmann erkennt, dass die vorgenannten Bereichsgrenzen auch kombiniert werden können, um weitere bevorzugte Bereich zu erhalten, wie beispielsweise 200 nm bis 1 $\mu$m, 100 nm bis 5 $\mu$m oder 500 nm bis 10 $\mu$m.

Die bevorzugten Dicken für die dielektrische sowie elektrisch leitfähige Schicht führen zu ausgezeichnetem Schutz des MEMS-Elementes, bei gleichzeitig kompakter Ausführung und hoher Funktionalität.

In einer bevorzugten Ausführungsform betrifft die Erfindung ein Herstellungsverfahren für ein MEMS-Transducer-Package mit einem Schichtsystem zum Schutz des MEMS-Transducers, umfassend die folgenden Schritte:

- Bereitstellen eines MEMS-Bauelements aufweisend eine MEMS-Membran auf einem Substrat
- Bereitstellen eines Prozessors als integrierte Schaltung auf dem Substrat, welche eine elektrische Verbindung mit dem MEMS-Baustein aufweist
- Sprühbeschichtung von MEMS-Bauelement, integrierter Schaltung und bevorzugt elektrischer Verbindung mit einer dielektrischen Schicht, sodass MEMS-Bauelement, integrierte Schaltung und elektrische Verbindung vollständig zwischen dielektrischer Schicht und Substrat umfasst sind
- Aufbringen einer elektrisch-leitenden Schicht mindestens bereichsweise auf die dielektrische Schicht, wobei die dielektrische Schicht und die elektrisch-leitende Schicht sich über das MEMS-Bauelement und den Prozessor erstrecken.

MEMS-Bauelement mit MEMS-Membran sowie integrierte Schaltung auf dem Substrat inklusive elektrische Verbindung umfassen bevorzugt den MEMS-Transducer. Der MEMS-Transducer ist insbesondere ein PMUT, ein CMUT oder eine PC-MUT. Bevorzugt ist die elektrische Verbindung mindestens ein Drahtbond.

Die bevorzugten Ausführungsformen und beschriebenen Vorteile für das MEMS-Package kommen ebenso und in besonderem Maße bei dem bevorzugte MEMS-Tranducer-Package zum Tragen.

Das hergestellte Schichtsystem umfassend eine dielektrische Schicht und eine elektrisch leitende Schicht ist äußerst kompakt und einfach herzustellen, bietet vollwertigen Schutz des MEMS-Transducers. Besonders vorteilhaft werden die akustischen Eigenschaften des MEMS-Transducers hierbei nicht vermindert.

In einer bevorzugten Ausführungsform der Erfindung liegt ein Rückvolumen des MEMS-Transducers zwischen Substrat und MEMS-Membran angeordnet vor und folgender Schritt ist umfasst:

- Anordnung einer Schallöffnung oberhalb der Membran durch zumindest bereichsweises Entfernen der Schicht oder des Schichtsystems oberhalb der Membran.

Das Entfernen kann beispielsweise durch einen Ätzprozess der durch physikalische Bearbeitung der Schicht(en) erfolgen.

Wenn die elektrisch leitende Schicht bereits anfänglich in diesem Bereich nicht aufgebracht wurde, muss nur die dielektrische Schicht entfernt werden. Ansonsten müssen sowohl dielektrische als auch elektrisch-leitenden Schicht entfernt werden. Dies geschieht insbesondere so, dass die Membran danach zumindest bereichsweise nicht bedeckt ist, um die akustischen Eigenschaften des MEMS-Transducers zu erhalten bzw. dass zumindest bereichsweise ein direkter Kontakt der Membran zum Schallmedium besteht. Da das Schichtsystem direkt bündig auf dem MEMS-Transducer aufliegt, kann ein direkter Kontakt zwischen Membran und dem Schallmedium hergestellt werden, ohne dass das Schallmedium in sonstige Bereiche des MEMS-Transducers gelangen kann. So kann ein umfassender Schutz vor Feuchte und Flüssigkeit bei gleichzeitigem Erhalt der akustischen Eigenschaften erreicht werden. Durch das bündige Abschließen von Schallöffnung und Membran werden auch die akustischen Eigenschaften des MEMS-Transducers verbessert.

Es ist insbesondere bevorzugt, dass dieser Schritt zwischen der Sprühbeschichtung und dem Aufbringen der elektrisch leitenden Schicht vorgenommen wird. Die Sprühbeschichtung kann dann beispielsweise durch ein Lithographieverfahren entfernt werden. Wird die elektrisch leitende Schicht, insbesondere die metallische Schicht, erst nach Entfernen der dielektrischen Schicht vorgenommen, kann sichergestellt werden, dass die elektrisch leitende Schicht die Randbereiche der Schallöffnung bündig mit dem MEMS-Baustein abschließt, wodurch die Dichtigkeit des Package an dieser Stelle gewährleistet werden kann, insbesondere gegenüber Gas (insbesondere Luft), Feuchte und/oder Flüssigkeiten.

Insbesondere ein CMUT umfasst vorzugsweise zwei MEMS-Membranen. In dieser Ausführungsform mit Schallöffnung im Schichtsystem kann es vorteilhafterweise reichen, wenn die untere Membran hermetisch gegenüber der Packageumgebung ist.

In einer bevorzugten Ausführungsform der Erfindung ist die Anordnung der dielektrischen Schicht, des Schichtsystems, des MEMS-Bauelements und/oder der MEMS-Membran dergestalt, dass nach Entfernen der Schicht oder des Schichtsystems keine elektrisch leitenden Bereiche in direktem Kontakt mit einer Packageumgebung stehen. Insbesondere sind diese gegenüber Luft und/oder Flüssigkeit abgedichtet.

In einer weiteren bevorzugten Ausführungsform der Erfindung liegen Elektroden des kapazitiven MEMS-Transducers, insbesondere des kapazitiven mikromechanischen Ultraschalltransducers im oder zum Rückvolumen angeordnet vor. Sie befinden sich z. B. im Rückvolumen oder auf der dem Rückvolumen zugewandten Seite der Membran. So können Kurzschlüsse durch Feuchtigkeit und Flüssigkeiten oder Verunreinigungen vermieden werden.

In einer bevorzugten Ausführungsform kann ein MEMS-Interaktionsbereich erst nach dem Aufbringen oder Entfernen der dielektrischen Schicht oder des Schichtsystem in einen beweglichen Zustand versetzt, bevorzugt durch einen Freistellungsprozess, insbesondere durch Entfernen einer Opferschicht.

Hierdurch können insbesondere für mechanisch empfindliche und fein strukturiert MEMS-Interaktionsbereiche, sichergestellt werden, dass die Schritte des Packaging-Verfahrens keinen negativen Einfluss auf deren Funktionalität haben. Stattdessen erfolgt eine bevorzugter Freistellungsprozess des MEMS-Interaktionsbereiches erst nach dem Aufbringen der dielektrischen Schicht oder des Schichtsystem und ggf. einer gezielten Entfernung im MEMS-Interaktionsbereich, als eine der letzten Verfahrensschritte.

Ein Beispiel für ein mechanisch empfindliche und fein strukturiert MEMS-Interaktionsbereich ist eine MEMS-Membran im Falle eines MEMS-Transducer als MEMS-Element.

In einer bevorzugten Ausführungsform wird die MEMS-Membran erst nach dem Aufbringen oder Entfernen der Schicht oder des Schichtsystem in einen schwingfähigen Zustand versetzt, bevorzugt durch einen Freistellungsprozess, insbesondere durch Entfernen einer Opferschicht.

Die MEMS-Membran ist ein entscheidendes Bauteil eines MEMS-Transducers. Gleichzeitig ist eine solche Membran besonders fein strukturiert und empfindlich, um die gewünschten akustischen Eigenschaften zu erhalten. Daher kann das Aufbringen des Schichtsystems oder der Prozess des Entfernens der Schicht oder des Schichtsystems für die Schallöffnung die Membran beeinträchtigen oder gar zerstören.

Deswegen wird die Membran vorzugsweise erst nachher in einen schwingfähigen Zustand versetzt, insbesondere dadurch, dass eine dafür vorgesehene und entsprechend strukturierte Opferschicht entfernt wird, welche z. B. zwischen Membran und den übrigen Transducer Komponenten vorliegt und die Membran so blockiert und schützt. Dies kann beispielsweise durch einen Ätzprozess erfolgen, wobei bevorzugt das überschüssige Material der Opferschicht aus dem Package entfernt wird. Die Opferschicht kann vorzugsweise gegenüber der Membran zum Frontvolumen hin angeordnet sein. Dann ist das Entfernen des Materials über die Schallöffnung möglich. Liegt die Opferschicht im Rückvolumen vor, wird das Material vorzugsweise durch geeignete kleine Kanäle bzw. Öffnungen entfernt. Diese können bevorzugt im Nachhinein verschlossen werden.

Eine solche Freistellung ist insbesondere bei CMUTs, PMUTs und PC-MUTs relevant. Die Vorteile übertragen sich gleichermaßen auf andere MEMS-Elemente.

In einem weiteren Aspekt betrifft die Erfindung ein MEMS-Package, herstellbar oder hergestellt durch das beschriebene Herstellungsverfahren.

Insbesondere betrifft die Erfindung ein MEMS-Package, umfassend

- ein Substrat

- ein
auf dem Substrat angeordnetes MEMS-Element aufweisend einen MEMS-Interaktionsbereich, wobei das MEMS-Element ein MEMS-Bauelement und einen Prozessor auf dem Substrat umfasst

- eine dielektrische Schicht zum Schutz des MEMS-Elementes, hergestellt durch eine oberflächenkonforme Beschichtung von dem MEMS-Element durch ein Beschichtungsverfahren mit einem Dielektrikum

- eine elektrisch leitenden Schicht mindestens bereichsweise auf der dielektrischen Schicht, wobei die dielektrische Schicht und die elektrisch leitende Schicht sich über das MEMS-Bauelement und den Prozessor erstrecken.

Der Fachmann erkennt, dass technische Merkmale, Definitionen und Vorteile bevorzugter Ausführungsformen des beschriebenen Herstellungsverfahrens für ein MEMS-Package, ebenso für das erhaltene MEMS-Package gelten und umgekehrt.

Besonders bevorzugt ist, wie erläutert. eine Anwendung des erfindungsgemäßen Packaging-Verfahrens auf einen MEMS-Transducer.

In einer bevorzugten Ausführungsform betrifft die Erfindung daher auch einen MEMS-Package, welches eine MEMS-Transducer-Package ist, umfassend

- ein Substrat
- ein einen auf dem Substrat angeordnetes MEMS-Bauelement aufweisend eine MEMS-Membran, wobei ein Rückvolumen des MEMS-Transducers vorzugsweise zwischen Substrat und MEMS-Membran angeordnet vorliegt
- ein auf dem Substrat angeordneter Prozessor, vorzugsweise eine integrierte Schaltung, welcher eine elektrische Verbindung mit dem MEMS-Bauelement aufweist
- ein Schichtsystem zum Schutz des MEMS-Transducers, hergestellt durch folgende Schritte:

  a. Oberflächenkonforme Beschichtung, vorzugsweise Sprühbeschichtung von MEMS-Bauelement, Prozessor und bevorzugt elektrischer Verbindung mit einer dielektrischen Schicht insbesondere eines photostrukturierbaren Polymers, sodass MEMS-Bauelement, Prozessor, vorzugsweise eine integrierte Schaltung, und elektrische Verbindung vollständig zwischen dielektrischer Schicht und Substrat umfasst sind

  b. Aufbringen einer elektrisch-leitenden Schicht mindestens bereichsweise auf die dielektrische Schicht, wobei die dielektrische Schicht und die elektrisch leitende Schicht sich über das MEMS-Bauelement und den Prozessor erstrecken

  c. optional Anordnung einer Schallöffnung oberhalb der MEMS-Membran durch bereichsweises Entfernen der dielektrischen Schicht oder des Schichtsystems oberhalb der Membran, insbesondere durch ein Lithographie- und/oder Lift-off-Verfahren.

Bevorzugt kann hierbei die Anordnung des Schichtsystems, des MEMS-Bauelements und/oder der MEMS-Membran dergestalt sein, dass nach Entfernen der dielektrischen Schicht oder des Schichtsystems keine elektrisch leitenden Bereiche in direktem Kontakt mit einer Packageumgebung stehen und/oder ein Rückvolumen und elektrisch leitende Bereiche des MEMS-Transducers gegenüber Luft und/oder Flüssigkeiten abgedichtet sind, wobei das Rückvolumen des MEMS-Transducers vorzugsweise zwischen Substrat und MEMS-Membran angeordnet vorliegt und das MEMS-Transducer-Package eine Schallöffnung oberhalb der Membran aufweist.

## DETAILLIERTE BESCHREIBUNG

Die Erfindung soll im Folgenden unter Verweis auf weitere Abbildungen und Beispiele erläutert werden. Die Beispiele und Abbildungen dienen der Illustration bevorzugter Ausführungsform der Erfindung, ohne diese zu beschränken.

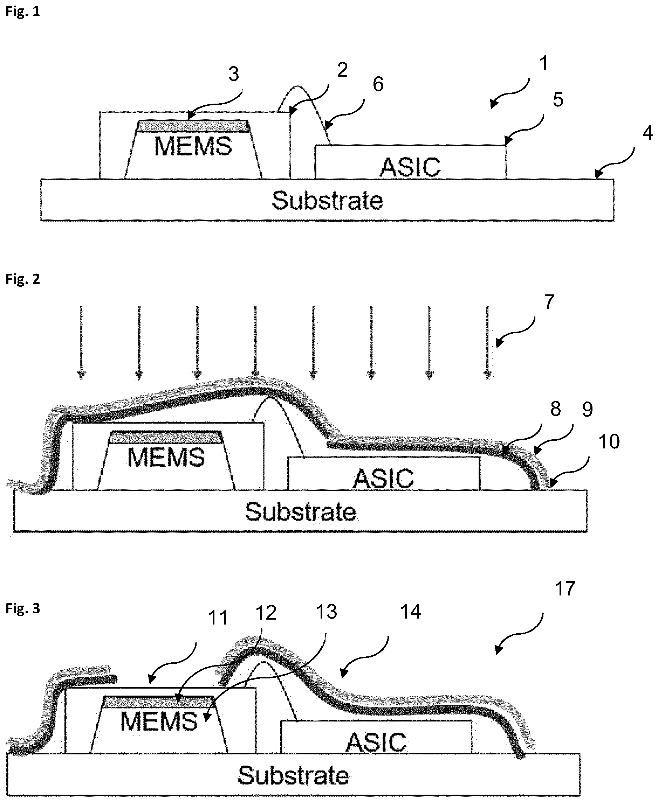

Figuren 1 bis 4 illustrieren eine bevorzugte Ausführungsform des Herstellungsverfahrens für ein MEMS-Package, am Beispiel eines MEMS-Transducer Package **14**.

Figur 1 zeigt einen MEMS-Transducer **1** ohne fertiges Package **14**. MEMS-Baustein **2** (wird auch als MEMS-Bauelement bezeichnet) mit MEMS-Membran **3** liegen auf einem Substrat **4** vor. Ebenfalls ist ein IC **5** (hier in Form eines ASIC) auf dem Substrat **4** angeordnet. MEMS-Baustein **2** und IC **5** sind hier über einen Drahtbond **6** elektrisch verbunden.

In Figur 2 wird das Aufbringen des Schichtsystems **16** zum Schutz des MEMS-Transducers **1** schematisch dargestellt. Zunächst wird eine oberflächenkonforme Beschichtung (z. B. Sprühbeschichtung) **7** mit einem Dielektrikum vorgenommen, welches sämtliche auf dem Substrat vorliegende Bauteile mit einer dielektrischen Schicht **8** beschichtet. Somit schließt diese Schicht diese Bauteile, also hier MEMS-Baustein **2**, IC **5** und Drahtbond **6** zwischen sich und Substrat **4** ein und ist im Wesentlichen enganliegend. Sodann wird eine elektrisch leitende Schicht **9** auf die dielektrische Schicht **8** aufgebracht, welche auch die Außenrandbereiche der dielektrischen Schicht **8** überdeckt und am äußeren Rand der Beschichtung mit dem Substrat **4** vorzugsweise bündig abschließt, um dort eine gute Abdichtung zu erhalten.

Figur 3 zeigt ein MEMS-Transducer Package **14**, welches den MEMS-Transducer **1** von der Packageumgebung **17** trennt und so schützt. Der MEMS-Baustein **2** ist so angeordnet, dass das Rückvolumen **13** zwischen Membran 3 und Substrat **4** liegt. Daher wird eine Schallöffnung **11** oberhalb der Membran in das Schichtsystem **16** eingebracht, in dem oberhalb der Membran **3** beide Schichten **8, 9** entfernt werden, bspw. durch ein Lithographieverfahren. Die Membran **3** liegt hier als nicht freigestellte Membran vor, welche vorerst durch eine Opferschicht **12** geschützt wird.

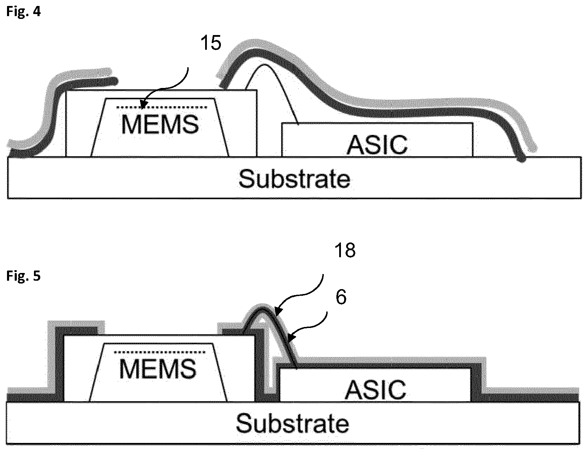

In Figur 4 wurde eine freigestellte Membran **15** durch Entfernen der Opferschicht **12** hergestellt.

Figur 5 zeigt ein bevorzugt vollständig oberflächenkonformes Package, bei dem mittels Gasphasenabscheidung eines Polymers (z.B. Parylene) ein vollständig oberflächen konformes Schichtsystem **18** erzeugt wird. Es wird dargestellt, wie enganliegend ein so erzeugtes Schichtsystem ist, bei dem sogar die Struktur des Drahtbonds **6** nach der Beschichtung im Package **14** erhalten bleibt.

## BEZUGSZEICHENLISTE

| | |
|---|---|
| 1 | MEMS-Element, beispielsweise MEMS-Transducer |
| 2 | MEMS-Baustein bzw. MEMS-Bauelement |
| 3 | MEMS-Interaktionsbereich, beispielsweise MEMS-Membran |
| 4 | Substrat |
| 5 | Prozessor, vorzugsweise Integrierte Schaltung (IC) |
| 6 | Elektrische Verbindung, vorzugsweise Drahtbond |
| 7 | Oberflächenkonforme Beschichtung (z. B. Sprühbeschichtung) |
| 8 | Dielektrische Schicht |
| 9 | Elektrisch-leitende Schicht |
| 10 | Äußerer Rand der Beschichtung |
| 11 | Öffnung vor dem MEMS-Interaktionsbereich, vorzugsweise Schallöffnung |
| 12 | Opferschicht des nicht freigestellten Interaktionsbereiches, beispielsweise einer nicht freigestellten Membran |
| 13 | Rückvolumen |
| 14 | MEMS-Package, beispielsweise MEMS-Transducer-Package |
| 15 | Freigestellter MEMS-Interaktionsbereich, beispielsweise freigestellte MEMS-Membran |
| 16 | Schichtsystem |
| 17 | Packageumgebung |
| 18 | Oberflächenkonformes Schichtsystem |

## LITERATUR

Alfons Dehé, Martin Wurzer, Marc Füldner und Ulrich Krumbein, The Infineon Silicon MEMS Microphone, AMA Conferences 2013 - SENSOR 2013, OPTO 2013, IRS 2 2013

Gregor Feiertag, Wolfgang Pahl, Matthias Winter, Anton Leidl, Stefan Seitz, Christian Siegel, Andreas Beer, Flip chip MEMS microphone package with large acoustic reference volume, Proc. Eurosensors XXIV, September 5-8, 2010, Linz, Austria

M. Härth, D. W. Schubert, Simple Approach for Spreading Dynamics of Polymeric Fluids. In: Macromol. Chem. Phys. 213, Nr. 6, März 2012, S. 654-665.

**Patentansprüche**

1. Herstellungsverfahren für ein MEMS-Package (14) mit mindestens einer Schicht zum Schutz eines MEMS-Elements (1), umfassend folgende Schritte:

   - Bereitstellen eines MEMS-Elements (1) aufweisend mindestens einen MEMS-Interaktionsbereich (3) auf einem Substrat (4), wobei das MEMS-Element (1) ein MEMS-Bauelement (2) und einen Prozessor (5) auf dem Substrat (4) umfasst und eine elektrische Verbindung (6) zwischen MEMS-Bauelement (2) und Prozessor (5) vorliegt,
   - oberflächenkonforme Beschichtung von dem MEMS-Element (1) mit einer dielektrischen Schicht (8), **gekennzeichnet durch**
   - Aufbringen einer elektrisch leitenden Schicht (9) mindestens bereichsweise auf die dielektrische Schicht (8), wobei die dielektrische Schicht (8) und die elektrisch-leitende Schicht (9) sich über das MEMS-Bauelement (2) und den Prozessor (5) erstrecken.

2. Herstellungsverfahren nach dem vorherigen Anspruch,
   **dadurch gekennzeichnet, dass**
   das MEMS-Element (1) ausgesucht ist aus der Gruppe: akustischer MEMS-Transducer, optischer MEMS-Transducer, MEMS-Sensor, insbesondere MEMS-Gassensor und/oder MEMS-Filter.

3. Herstellungsverfahren nach einem oder mehreren der vorherigen Ansprüche,
   **dadurch gekennzeichnet, dass**
   die oberflächenkonforme Beschichtung durch ein Beschichtungsverfahren mit einem Dielektrikum vorgenommen wird, welches ausgesucht ist aus der Gruppe: Sprühbeschichtung, Nebelbeschichtung. Dampfbeschichtung und/oder galvanische Beschichtung.

4. Herstellungsverfahren nach einem oder mehreren der vorherigen Ansprüche,
   **dadurch gekennzeichnet, dass**
   die oberflächenkonforme Beschichtung durch eine zumindest bereichsweise das MEMS-Element (1) benetzende Beschichtung erfolgt, wobei es bevorzugt sein kann, dass im MEMS-Interaktionsbereich (3) eine entnetzende Beschichtung erfolgt.

5. Herstellungsverfahren nach einem oder mehreren der vorherigen Ansprüche,
   **dadurch gekennzeichnet, dass**
   die dielektrische Schicht und/oder das Dielektrikum (8) ein Polymer umfasst, bevorzugt ein photostrukturierbares Polymer, ein Polymethylmethacrylat, ein Polyimid, Novolak, Polymethylglutarimid, aus der Gas- und/oder Flüssigphase abscheidbare Polymere, insbesondere Tetraethylorthosilicat (TEOS), Parylene und/oder Epoxidharz, insbesondere SU-8

6. Herstellungsverfahren nach einem oder mehreren vorherigen Ansprüchen,
   **dadurch gekennzeichnet, dass**

   die elektrisch leitende Schicht (9) Metall, vorzugsweise Aluminium und/oder ein Edelmetall, bevorzugt Gold, Platin, Iridium, Palladium, Osmium, Silber, Rhodium und/oder Ruthenium umfasst und/oder
   die elektrisch leitende Schicht (9) durch ein Beschichtungsverfahren, insbesondere durch ein PVD-, CVD- und/oder ein Sputterverfahren aufgebracht wird.

7. Herstellungsverfahren nach einem oder mehreren der vorherigen Ansprüche,
   **dadurch gekennzeichnet, dass**
   MEMS-Element (1) und/oder Prozessor (5) in einer Flip-Chip Bauweise montiert sind und vorzugsweise die elektrische Verbindung (6) über das Substrat (4) erfolgt und/oder MEMS-Element (1) und/oder Prozessor (5) in einer konventionellen Bauweise und nicht in einer Flip-Chip Bauweise vorliegen und vorzugsweise die elektrische Verbindung (6) über mindestens einen Drahtbond erfolgt.

8. Herstellungsverfahren nach einem oder mehreren der vorherigen Ansprüche für ein MEMS-Package (14) mit vorzugsweise einem Schichtsystem (16) zum Schutz des MEMS-Elements (1) umfassend ein MEMS-Bauelement und einen Prozessor (5), umfassend die folgenden Schritte:

   - Bereitstellen des MEMS-Bauelementes (2) aufweisend einen MEMS-Interaktionsbereich (3) auf dem Substrat (4),
   - Bereitstellen des Prozessors (5) auf dem Substrat (4), welcher eine elektrische Verbindung (6) mit dem MEMS-Bauelement (2) aufweist,
   - Oberflächenkonforme Beschichtung, insbesondere Sprühbeschichtung (7) von dem MEMS-Bauelement (2), Prozessor (5) und bevorzugt elektrischer Verbindung (6) mit der dielektrischen Schicht (8), sodass das MEMS-Bauelement (2), Prozessor (5) und elektrische Verbindung (6) vollständig zwischen dielektrischer Schicht (8) und Substrat (4) umfasst ist,
- Aufbringen einer elektrisch-leitenden Schicht (9) mindestens bereichsweise auf die dielektrische Schicht (8), welche mit der dielektrischen Schicht (8) ein Schichtsystem (16) bildet
- optional Anordnung einer Öffnung (11) oberhalb des MEMS-Interaktionsbereichs (3) durch zumindest bereichsweises Entfernen der dielektrischen Schicht (8) und/oder des Schichtsystems (16) oberhalb des MEMS-Interaktionsbereichs (3).

9. Herstellungsverfahren nach einem oder mehreren der vorherigen Ansprüche,
   **dadurch gekennzeichnet, dass**
   ein Entfernen der dielektrischen Schicht (8) durch ein lithographisches Verfahren oder ein Lift-Off erfolgt, wobei bevorzugt die dielektrischen Schicht (8) durch ein photostrukturierbares Polymer gebildet wird und eine Vorstrukturierung der dielektrischen Schicht (8) durch entsprechende Belichtung des photostrukturierbaren Polymers vorgenommen wird.

10. Herstellungsverfahren nach einem oder mehreren der vorherigen Ansprüche,
    **dadurch gekennzeichnet, dass**

    die Schichtdicke der dielektrischen Schicht (8) zwischen 10 nm und 1 mm beträgt und/oder
    die Schichtdicke einer elektrischen leitenden Schicht (9) zwischen 10 nm und 20 $\mu$m beträgt.

11. Herstellungsverfahren nach einem der vorherigen Ansprüche,
    **dadurch gekennzeichnet, dass**

    das MEMS-Element (1) ein optischer MEMS-Transducer ist, und der MEMS-Interaktionsbereich (3) einen optischen Emitter und/oder einen optischen Empfänger umfasst,
    das MEMS-Element (1) ein akustischer MEMS-Transducer ist und der MEMS-Interaktionsbereich (3) eine MEMS-Membran umfasst,
    das MEMS-Element (1) ein MEMS-Gassensor ist und der MEMS-Interaktionsbereich (3) eine MEMS-Membran und oder einen elektro-chemischen MEMS-Sensorbereich umfasst oder, das MEMS-Element (1) ein MEMS-Filter, bevorzugt ein MEMS-Frequenzfilter, insbesondere ein SAW- oder BAW-Filter ist und wobei der MEMS-Interaktionsbereich (3) eine MEMS-Filterstruktur, insbesondere MEMS-Elektroden und/oder einen MEMS-Bulkbereich umfasst.

12. Herstellungsverfahren nach einem oder mehreren der vorherigen Ansprüche,

**dadurch gekennzeichnet, dass**
das MEMS-Element (1) ein akustischer MEMS-Transducer ist und ein MEMS-Bauelement und einen Prozessor (5) aufweist und das Herstellungsverfahren folgende Schritte umfasst:

- Bereitstellen des MEMS-Bauelements (2) aufweisend eine MEMS-Membran (3) auf einem Substrat (4)
- Bereitstellen des Prozessors (5) auf dem Substrat (4), welcher eine elektrische Verbindung (6) mit dem MEMS-Bauelement (2) aufweist
- Oberflächenkonforme Beschichtung, insbesondere Sprühbeschichtung (7), von MEMS-Bauelement (2), Prozessor (5) und bevorzugt elektrischer Verbindung (6) mit der dielektrischen Schicht (8), sodass MEMS-Bauelement (2), Prozessor (5) und elektrische Verbindung (6) vollständig zwischen dielektrischer Schicht (8) und Substrat (4) umfasst sind
- Optional Aufbringen einer elektrisch-leitenden Schicht (9) mindestens bereichsweise auf die dielektrische Schicht (8), welche mit der dielektrischen Schicht (8) ein Schichtsystem (16) bildet
- Optional Anordnung einer Schallöffnung (11) oberhalb der MEMS-Membran (3) durch zumindest bereichsweises Entfernen der dielektrischen Schicht (8) oder des Schichtsystems (16) oberhalb der Membran (3).

13. MEMS- Package (14), umfassend

    - ein Substrat (4)
    - ein auf dem Substrat (4) angeordnetes MEMS-Element (1) aufweisend einen MEMS-Interaktionsbereich (3), wobei das MEMS-Element (1) ein MEMS-Bauelement (2) und einen Prozessor (5) auf dem Substrat (4) umfasst und eine elektrische Verbindung (6) zwischen MEMS-Bauelement (2) und Prozessor (5) vorliegt,
    - eine dielektrische Schicht (8) zum Schutz des MEMS-Elementes (1), hergestellt durch eine oberflächenkonforme Beschichtung von dem MEMS-Element (1) durch ein Beschichtungsverfahren mit einem Dielektrikum, **gekennzeichnet durch**
    - eine elektrisch leitenden Schicht (9) mindestens bereichsweise auf der dielektrischen Schicht (8), wobei die dielektrische Schicht (8) und die elektrisch leitende Schicht (9) sich über das MEMS-Bauelement (2) und den Prozessor (5) erstrecken.

**Claims**

1. Production method a MEMS package (14) having at least one layer for protecting a MEMS device (1), comprising the following steps:

- Providing a MEMS device (1) comprising at least one MEMS interaction region (3) on a substrate (4), wherein the MEMS element (1) comprises a MEMS device (2) and a processor (5) on the substrate (4) and an electrical connection (6) is present between the MEMS device (2) and the processor (5),
- Surface conformal coating of the MEMS device (1) with a dielectric layer (8), **characterized in that**
- Application of an electrically conductive layer (9) at least in regions on the dielectric layer (8), wherein the dielectric layer (8) and the electrically conductive layer (9) extend over the MEMS device (2) and the processor (5).

2. Production method according to the preceding claim, **characterized in that** the MEMS element (1) is selected from the group: acoustic MEMS transducer, optical MEMS transducer, MEMS sensor, in particular MEMS gas sensor and/or MEMS filter.

3. Production method according to one or more of the preceding claims, **characterized in that** the surface conformal coating is implemented by a coating process with a dielectric selected from the group: spray coating, mist coating, vapor coating and/or electroplating.

4. Production method according to one or more of the preceding claims, **characterized in that** the surface conformal coating is implemented by a coating wetting the MEMS element (1) at least in regions, wherein it may be preferred that a wetting coating is implemented in the MEMS interaction region (3).

5. Production method according to one or more of the preceding claims, **characterized in that** the dielectric layer and/or the dielectric (8) comprises a polymer, preferably a photostructurable polymer, a polymethyl methacrylate, a polyimide, novolak, polymethyl glutarimide, polymers depositable from the gas and/or liquid phase, in particular tetraethyl orthosilicate (TEOS), parylene and/or epoxy resin, in particular SU-8.

6. Production method according to one or more of the preceding claims, **characterized in that**

the electrically conductive layer (9) comprises metal, preferably aluminum and/or a noble metal, preferably gold, platinum, iridium, palladium, osmium, silver, rhodium and/or ruthenium and/or
the electrically conductive layer (9) is applied by a coating process, in particular by a PVD, CVD and/or sputtering process.

7. Production method according to one or more of the preceding claims, **characterized in that**

the MEMS device (2) and/or processor (5) are mounted in a flip-chip design and preferably the electrical connection (6) is made via the substrate (4) and/or
the MEMS device (2) and/or processor (5) are present in a conventional design and not in a flip-chip design and preferably the electrical connection (6) is made via at least one wire bond.

8. Production method according to one or more of the preceding claims for a MEMS package (14) with preferably a layer system (16) for protecting the MEMS element (1), comprising the MEMS device (2) and the processor (5) comprising the following steps:

- Providing the MEMS device (2) comprising a MEMS interaction region (3) on the substrate (4)
- Providing the processor (5) on the substrate (4), which has an electrical connection (6) with the MEMS device (2),
- Surface conformal coating, in particular spray coating (7) of the MEMS device (2), processor (5) and preferably the electrical connection (6) with the dielectric coating (8), such that the MEMS device (2), the processor (5) and the electrical connection (6) is completely enclosed between dielectric layer (8) and substrate (4)
- Applying an electrically conductive layer (9) at least in regions onto the dielectric layer (8), which forms a layer system (16) with the dielectric layer (8)
- Optionally arranging an opening (11) above the MEMS interaction regions (3) by removing the dielectric layer (8) and/or the layer system (16) at least in some regions above the MEMS interaction region (3).

9. Production method according to one or more of the preceding claims, **characterized in that** a removal of the dielectric layer (8) is performed by a lithographic process or a lift-off, wherein preferably the dielectric layer (8) is formed by a photostructurable polymer and a pre-structuring of the dielectric layer (8) is performed by corresponding exposure of the photostructurable polymer to light.

**10.** Production process according to one or more of the preceding claims,
**characterized in that**

the layer thickness of the dielectric layer (8) is between 10 nm and 1 mm
and/or
the layer thickness of an electrically conductive layer (9) is between 10 nm and 20 μm.

**11.** Production method according to any one of the preceding claims,
**characterized in that**

the MEMS element (1) is an optical MEMS transducer, and the MEMS interaction region (3) comprises an optical emitter and/or an optical receiver,
the MEMS element (1) is an acoustic MEMS transducer and the MEMS interaction region (3) comprises a MEMS membrane,
the MEMS element (1) is a MEMS gas sensor and the MEMS interaction region (3) comprises a MEMS membrane and or an electro-chemical MEMS sensor region or
the MEMS element (1) is a MEMS filter, preferably a MEMS frequency filter, in particular a SAW or BAW filter, and wherein the MEMS interaction region (3) comprises a MEMS filter structure, in particular MEMS electrodes and/or a MEMS bulk region.

**12.** Production method according to one or more of the preceding claims,
**characterized in that**
the MEMS element (1) is a MEMS acoustic transducer and comprises a MEMS device and a processor (5), and the production method comprises the following steps:

- Providing the MEMS device (2) comprising a MEMS membrane (3) on a substrate (4)
- Providing the processor (5) on the substrate (4), which has an electrical connection (6) to the MEMS device (2)
- Surface conformal coating, in particular spray coating (7), of MEMS device (2), processor (5) and preferably electrical connection (6) with the dielectric layer (8), such that MEMS device (2), processor (5) and electrical connection (6) are completely enclosed between dielectric layer (8) and substrate (4)
- Optionally applying an electrically conductive layer (9) at least in some regions on the dielectric layer (8), which forms a layer system (16) with the dielectric layer (8)

- Optional arrangement of a sound port (11) above the MEMS membrane (3) by removing the dielectric layer (8) or layer system (16) at least in some regions above the membrane (3).

**13.** MEMS package (14), comprising

- a substrate (4)
- a MEMS element (1) arranged on the substrate (4) comprising a MEMS interaction region (3), wherein the MEMS element (1) comprises a MEMS device (3) and a processor (5) on the substrate (4) and an electrical connection (6) is present between the MEMS device (2) and the processor (5),
- a dielectric layer (8) for protecting the MEMS element (1), produced by surface conformal coating of the MEMS element (1) by a dielectric coating process,
- an electrically conductive layer (9) at least in regions on the dielectric layer (8), wherein the dielectric layer (8) and the electrically conductive layer (9) extend over the MEMS device (2) and the processor (5).

**Revendications**

**1.** Procédé de fabrication d'un boîtier microélectromécanique (14) avec au moins une couche de protection d'un élément microélectromécanique (1), comprenant les étapes suivantes :

- la fourniture d'un élément microélectromécanique (1) ayant au moins une région d'interaction microélectromécanique (3) sur un substrat (4), dans lequel l'élément microélectromécanique (1) comprend un composant microélectromécanique (2) et un processeur (5) sur le substrat (4) et présente une connexion électrique (6) entre le composant microélectromécanique (2) et le processeur (5),
- le revêtement conforme à la surface de l'élément microélectromécanique (1) avec une couche diélectrique (8), **caractérisé par**
- l'application d'une couche électriquement conductrice (9) au moins partiellement sur la couche diélectrique (8), dans lequel la couche diélectrique (8) et la couche électriquement conductrice (9) s'étendent sur le composant microélectromécanique (2) et le processeur (5).

**2.** Procédé de fabrication selon la revendication précédente, **caractérisé en ce que**
l'élément microélectromécanique (1) est choisi dans le groupe : d'un transducteur microélectromécanique acoustique, d'un transducteur microélectromécanique optique, d'un capteur microélectromécanique, notamment d'un capteur de gaz microélectromécanique et/ou d'un filtre microélectromécanique.

3. Procédé de fabrication selon l'une ou plusieurs des revendications précédentes,
**caractérisé en ce que**
le revêtement conforme à la surface est réalisé par un procédé de revêtement avec un diélectrique choisi dans le groupe : d'un revêtement par pulvérisation, d'un revêtement par brouillard, d'un revêtement à la vapeur et/ou d'un revêtement galvanique.

4. Procédé de fabrication selon l'une ou plusieurs des revendications précédentes,
**caractérisé en ce que**
le revêtement conforme à la surface est réalisé par un revêtement qui mouille au moins partiellement l'élément microélectromécanique (1), dans lequel, de préférence, un revêtement de démouillage peut être réalisé dans la zone d'interaction microélectromécanique (3).

5. Procédé de fabrication selon l'une ou plusieurs des revendications précédentes,
**caractérisé en ce que**
la couche diélectrique et/ou le diélectrique (8) comprend un polymère, de préférence un polymère photostructurable, un polyméthacrylate de méthyle, un polyimide, une novolaque, un polyméthylglutarimide, des polymères déposables à partir de la phase gazeuse et/ou liquide, notamment de l'orthosilicate de tétraéthyle (TEOS), de la résine parylène et/ou époxy, notamment SU-8.

6. Procédé de fabrication selon l'une ou plusieurs des revendications précédentes,
**caractérisé en ce que**
la couche électriquement conductrice (9) comprend du métal, de préférence de l'aluminium et/ou un métal noble, de préférence de l'or, du platine, de l'iridium, du palladium, de l'osmium, de l'argent, du rhodium et/ou du ruthénium et/ou la couche électriquement conductrice (9) est appliquée par un procédé de revêtement, en particulier par un procédé PVD, CVD et/ou de pulvérisation cathodique.

7. Procédé de fabrication selon l'une ou plusieurs des revendications précédentes,
**caractérisé en ce que**

l'élément microélectromécanique (1) et/ou le processeur (5) sont montés dans une conception à puce retournée et la connexion électrique (6) s'effectue de préférence via le substrat (4) et/ou
l'élément microélectromécanique (1) et/ou le processeur (5) sont de conception conventionnelle et non à puce retournée et la connexion électrique (6) s'effectue de préférence via au moins une liaison filaire.

8. Procédé de fabrication selon une ou plusieurs des revendications précédentes pour un boîtier microélectromécanique (14) avec de préférence un système de couches (16) de protection de l'élément microélectromécanique (1) comprenant un composant microélectromécanique et un processeur (5), comprenant les étapes suivantes :

   - la fourniture du composant microélectromécanique (2) comportant une région d'interaction microélectromécanique (3) sur le substrat (4),
   - le placement du processeur (5) sur le substrat (4), lequel présente une connexion électrique (6) avec le composant microélectromécanique (2),
   - le revêtement conforme à la surface, en particulier le revêtement par pulvérisation (7) du composant microélectromécanique (2), du processeur (5) et de préférence de la connexion électrique (6) avec la couche diélectrique (8), de sorte que le composant microélectromécanique (2), le processeur (5) et la connexion électrique (6) sont entièrement englobés entre la couche diélectrique (8) et le substrat (4),
   - l'application d'une couche électriquement conductrice (9) au moins partiellement sur la couche diélectrique (8), qui forme un système de couches (16) avec la couche diélectrique (8)
   - l'agencement éventuel d'une ouverture (11) au-dessus de la région d'interaction microélectromécanique (3) en retirant au moins partiellement la couche diélectrique (8) et/ou le système de couches (16) au-dessus de la région d'interaction microélectromécanique (3).

9. Procédé de fabrication selon l'une ou plusieurs des revendications précédentes,
**caractérisé en ce que**
un enlèvement de la couche diélectrique (8) est effectué par un procédé lithographique ou un lift-off, dans lequel la couche diélectrique (8) est de préférence formée par un polymère pouvant être photostructuré et une préstructuration de la couche diélectrique (8) est effectuée par une exposition correspondante du polymère pouvant être photostructuré.

10. Procédé de fabrication selon l'une ou plusieurs des revendications précédentes,
**caractérisé en ce que**

l'épaisseur de la couche diélectrique (8) est comprise entre 10 nm et 1 mm et/ou
l'épaisseur d'une couche électriquement conductrice (9) est comprise entre 10 nm et 20 $\mu$m.

11. Procédé de fabrication selon l'une des revendications précédentes,
**caractérisé en ce que**

l'élément microélectomécanique (1) est un transducteur optique microélectomécanique, et la région d'interaction microélectomécanique (3) comprend un émetteur optique et/ou un récepteur optique,

l'élément microélectomécanique (1) est un transducteur microélectomécanique acoustique et la région d'interaction microélectomécanique (3) comprend une membrane microélectomécanique,

l'élément microélectomécanique (1) est un capteur de gaz microélectomécanique et la zone d'interaction microélectomécanique (3) comprend une membrane microélectomécanique et/ou une zone de capteur microélectomécanique électrochimique ou,

l'élément microélectromécanique (1) est un filtre microélectromécanique, de préférence un filtre de fréquence microélectromécanique, en particulier un filtre SAW ou BAW, et dans lequel la zone d'interaction microélectromécanique (3) comprend une structure de filtre microélectromécanique, en particulier des électrodes microélectromécanique et/ou une zone de bulk microélectromécanique.

12. Procédé de fabrication selon l'une ou plusieurs des revendications précédentes,
**caractérisé en ce que**
l'élément microélectromécanique (1) est un transducteur microélectromécanique acoustique et comporte un composant microélectromécanique et un processeur (5) et le procédé de fabrication comprend les étapes suivantes :

- la fourniture du composant microélectromécanique (2) ayant une membrane microélectromécanique (3) sur un substrat (4).
- le placement du processeur (5) sur le substrat (4), lequel présente une connexion électrique (6) avec le composant microélectromécanique (2)
- le revêtement conforme à la surface, en particulier le revêtement par pulvérisation (7) du composant microélectromécanique (2), du processeur (5) et de préférence de la connexion électrique (6) avec la couche diélectrique (8), de sorte que le composant microélectromécanique (2), le processeur (5) et la connexion électrique (6) sont entièrement englobés entre la couche diélectrique (8) et le substrat (4)
- l'application éventuelle d'une couche électriquement conductrice (9) au moins partiellement sur la couche diélectrique (8), qui forme un système de couches (16) avec la couche diélectrique (8)
- l'agencement éventuel d'une ouverture sonore (11) au-dessus de la membrane microélectromécanique (3) en retirant au moins partiellement la couche diélectrique (8) ou le système de couches (16) au-dessus de la membrane (3).

13. Boîtier microélectromécanique (14), comprenant

- un substrat (4)
- un élément microélectormécanique (1) disposé sur le substrat (4) et présentant une zone d'interaction microélectormécanique (3), dans lequel l'élément microélectormécanique (1) comprend un composant microélectormécanique (2) et un processeur (5) sur le substrat (4) et une connexion électrique (6) est présente entre le composant microélectormécanique (2) et le processeur (5),
- une couche diélectrique (8) pour protéger l'élément microélectormécanique (1), fabriquée par un revêtement conforme à la surface de l'élément microélectormécanique (1) par un processus de revêtement avec un diélectrique, **caractérisé par**
- une couche électriquement conductrice (9) au moins partiellement sur la couche diélectrique (8), dans lequel la couche diélectrique (8) et la couche électriquement conductrice (9) s'étendent sur le composant microélectromécanique (2) et le processeur (5).

**Fig. 1**

**Fig. 2**

**Fig. 3**

**Fig. 4**

**Fig. 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6956283 B1
- US 20190148566 A1

- US 20190311961 A1

**In der Beschreibung aufgeführte Nicht-Patentliteratur**

- **ALFONS DEHÉ ; MARTIN WURZER ; MARC FÜLDNER ; ULRICH KRUMBEIN.** The Infineon Silicon MEMS Microphone. *AMA Conferences 2013 - SENSOR 2013, OPTO 2013,* 2013
- **GREGOR FEIERTAG ; WOLFGANG PAHL ; MATTHIAS WINTER ; ANTON LEIDL ; STEFAN SEITZ ; CHRISTIAN SIEGEL ; ANDREAS BEER.** Flip chip MEMS microphone package with large acoustic reference volume, Proc. *Eurosensors XXIV,* 05. September 2010

- **M. HÄRTH ; D. W. SCHUBERT.** Simple Approach for Spreading Dynamics of Polymeric Fluids. *Macromol. Chem. Phys,* Marz 2012, vol. 213 (6), 654-665